# EUROPEAN PATENT APPLICATION

(11) **EP 4 273 306 A1**
(43) Date of publication of application: **08.11.2023**
(21) Application number: 21915312.9
(22) Date of filing: 28.12.2021
(51) Int. Cl.: C30B 25/04, C30B 25/18, H01L 21/205, C30B 29/38, C23C 16/04, C23C 16/34

(54) **SEMICONDUCTOR SUBSTRATE, SEMICONDUCTOR DEVICE AND ELECTRONIC DEVICE**

(30) Priority: 29.12.2020 JP 2020219850
(71) Applicant: Kyocera Corporation, Kyoto-shi Kyoto 612-8501 (JP)
(72) Inventor: KAMIKAWA, Takeshi, Kyoto-shi, Kyoto 612-8501 (JP); MASAKI, Katsuaki, Kyoto-shi, Kyoto 612-8501 (JP); KOBAYASHI, Toshihiro, Kyoto-shi, Kyoto 612-8501 (JP); HAYASHI, Yuichiro, Kyoto-shi, Kyoto 612-8501 (JP)
(74) Representative: Viering, Jentschura & Partner mbB Patent- und Rechtsanwälte
(86) International application number: PCT/JP2021/048835
(87) International publication number: WO 2022/145454

(57) **Abstract**

A semiconductor substrate includes a heterogeneous substrate (1), a mask layer (6) having an opening portion (KS) and a mask portion (5), a seed portion (3S) overlapping the opening portion, and a semiconductor layer (8) including a GaN-based semiconductor and disposed on the seed portion and the mask portion. An upper surface of an effective portion (YS) of the semiconductor layer includes at least one low-level defective region (AL) with a size of 10 µm in a first direction along a width direction of the opening portion and 10 µm in a second direction orthogonal to the first direction, and a line defect is not measured by a CL method in the low-level defective region (AL).

## Description

### TECHNICAL FIELD

The present invention relates to semiconductor substrates, semiconductor devices, and electronic devices.

### BACKGROUND OF INVENTION

A semiconductor device using gallium nitride (GaN) generally has higher power conversion efficiency than a semiconductor device made of silicon (Si). Because of this, a semiconductor device using GaN has a smaller power loss than a semiconductor device made of Si, and thus an energy saving effect is expected. In order to manufacture semiconductor devices using GaN, research has been conducted on a technique for forming GaN-based semiconductor elements. For example, Patent Document 1 discloses a technique for forming a GaN-based semiconductor layer on a GaN-based substrate or a heterogeneous substrate (for example, a sapphire substrate) by using an epitaxial lateral overgrowth (ELO) method.

### CITATION LIST

### PATENT LITERATURE

Patent Document 1: JP 2013-251304 A

### SUMMARY

A semiconductor substrate according to the present disclosure includes a main substrate having a lattice constant different from that of a GaN-based semiconductor, a mask layer located above the main substrate and including an opening portion and a mask portion, a seed portion overlapping the opening portion in a plan view, and a semiconductor layer including a GaN-based semiconductor and disposed on the seed portion and the mask portion. The semiconductor layer includes an effective portion located between the opening portion and a center of the mask portion in a plan view. An upper surface of the effective portion includes at least one low-level defective region with a size of 10 µm in a first direction along a width direction of the opening portion and 10 µm in a second direction orthogonal to the first direction. In the low-level defective region, a line defect is not measured by a CL method.

### BRIEF DESCRIPTION OF THE DRAWINGS

FIG. 1 includes a plan view and a cross-sectional view illustrating a configuration of a semiconductor substrate according to the present embodiment.
FIG. 2 is a cross-sectional view illustrating another configuration of the semiconductor substrate according to the present embodiment.
FIG. 3 is a cross-sectional view illustrating another configuration of the semiconductor substrate according to the present embodiment.
FIG. 4 includes a plan view and a cross-sectional view illustrating another configuration of the semiconductor substrate according to the present embodiment.
FIG. 5 includes a plan view and a cross-sectional view illustrating another configuration of the semiconductor substrate according to the present embodiment.
FIG. 6 is a cross-sectional view illustrating an element separation step according to the present embodiment.
FIG. 7 is a plan view illustrating the element separation step according to the present embodiment.
FIG. 8 is a cross-sectional view illustrating another example of the element separation step.
FIG. 9 is a cross-sectional view illustrating another example of the element separation step.
FIG. 10 is a cross-sectional view illustrating an element peeling step.
FIG. 11 is a cross-sectional view illustrating another example of the element peeling step.
FIG. 12 is a schematic view illustrating a configuration of an electronic device according to the present embodiment.
FIG. 13 is a schematic view illustrating another configuration of the electronic device according to the present embodiment.
FIG. 14 is a cross-sectional view illustrating an example of a lateral growth of a semiconductor layer.
FIG. 15 includes a plan view and a schematic view illustrating evaluation of the present semiconductor substrate (a configuration in which an ELO semiconductor layer has an edge face on a mask).
FIG. 16 includes a plan view and a schematic view illustrating evaluation of the present semiconductor substrate (a configuration in which an ELO semiconductor layer has an edge face on a mask).
FIG. 17 includes a plan view and a schematic view illustrating evaluation of the present semiconductor substrate (a configuration in which an ELO semiconductor layer has an edge face on a mask).
FIG. 18 includes a plan view and a schematic view illustrating evaluation of the present semiconductor substrate (a configuration in which an ELO semiconductor layer has an edge face on a mask).
FIG. 19 includes a plan view and a schematic view illustrating evaluation of an integrated-type semiconductor substrate in which an ELO semiconductor layer does not have an edge face on a mask.
FIG. 20 includes a plan view and a schematic view illustrating evaluation of an integrated-type semiconductor substrate in which an ELO semiconductor layer does not have an edge face on a mask.
FIG. 21 includes a plan view and a schematic view illustrating evaluation of an integrated-type semiconductor substrate in which an ELO semiconductor layer does not have an edge face on a mask.
FIG. 22 includes a plan view and a schematic view illustrating evaluation of an integrated-type semiconductor substrate in which an ELO semiconductor layer does not have an edge face on a mask.
FIG. 23 is a CL image obtained by taking an ELO semiconductor layer 8 in a semiconductor substrate 10 (a main substrate is a silicon substrate) as an imaging subject.
FIG. 24 is a CL image obtained by taking the ELO semiconductor layer 8 in the semiconductor substrate 10 (the main substrate is a sapphire substrate) as an imaging subject.
FIG. 25 is a CL image obtained by taking an ELO semiconductor layer back surface (peeled surface) in the semiconductor substrate 10 as an imaging subject.
FIG. 26 is a CL image of a surface of a GaN layer in a reference example.
FIG. 27 is a CL image of a surface of a GaN layer in a reference example.
FIG. 28 is a CL image of a surface of a GaN layer in a reference example.
FIG. 29 is a CL image obtained by taking, as an imaging subject, a back surface (peeled surface) of a GaN layer film formed by an ELO method in a reference example.
FIG. 30 is a CL image obtained by taking, as an imaging subject, a back surface (peeled surface) of a GaN layer film formed by the ELO method in a reference example.
FIG. 31 is a cross-sectional view illustrating a configuration of a semiconductor substrate of Example 1.
FIG. 32 is a cross-sectional view illustrating an example of peeling of a semiconductor layer in Example 1.
FIG. 33 is a cross-sectional view illustrating a configuration of a semiconductor substrate of Example 2.
FIG. 34 is a cross-sectional view illustrating a configuration of a semiconductor substrate of Example 3.
FIG. 35 is a cross-sectional view illustrating a configuration of a semiconductor substrate of Example 4.
FIG. 36 is a cross-sectional view illustrating an application example of Example 4.
FIG. 37 is a cross-sectional view illustrating a configuration of Example 5.
FIG. 38 is a cross-sectional view illustrating a configuration of Example 6.
FIG. 39 is a cross-sectional view illustrating another configuration of Example 6.
FIG. 40 is a block diagram illustrating a configuration example of a manufacturing apparatus of a semiconductor substrate.

### DESCRIPTION OF EMBODIMENTS

### Semiconductor Substrate

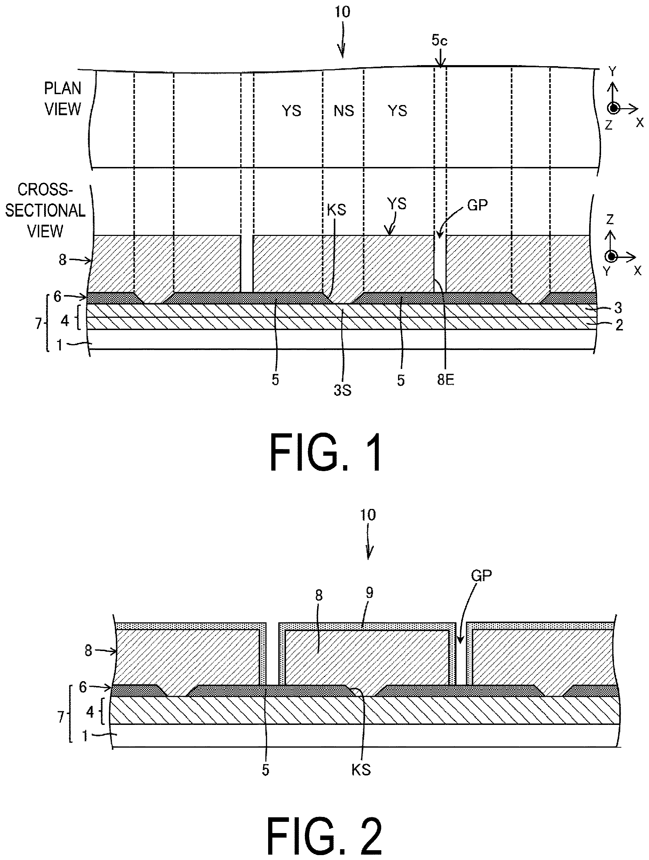

FIG. 1 includes a plan view and a cross-sectional view illustrating a configuration of a semiconductor substrate according to the present embodiment. As illustrated in FIG. 1, a semiconductor substrate 10 according to the present embodiment (semiconductor wafer) includes a main substrate 1, an underlying layer 4 formed on the main substrate 1 and including a seed portion 3S, a mask layer 6 formed on the underlying layer 4 and including an opening portion KS overlapping the seed portion 3S in a plan view and a mask portion 5, and a semiconductor layer 8 disposed on the seed portion 3S and the mask portion 5 and including a nitride semiconductor (for example, a GaN-based semiconductor). The underlying layer 4 may be referred to as an underlying portion 4, the mask layer 6 may be referred to as a mask 6 (mask pattern), and the semiconductor layer 8 may be referred to as a semiconductor part 8.

The opening portion KS of the mask layer 4 may have a tapered shape (a shape in which the width becomes narrower toward the underlying layer 4 side). In this case, the width of the opening portion KS and the width of the mask portion 5 may be expressed while taking the upper surface of the mask layer as a measurement subject. However, the aforementioned are not limited thereto.

A nitride semiconductor may be expressed, for example, by AlxGayInzN (0 ≤ x ≤ 1; 0 ≤ Y ≤ 1; 0 ≤ Z ≤ 1; X + Y + Z = 1). Specific examples may include a GaN-based semiconductor, aluminum nitride (AlN), indium aluminum nitride (InAlN), and indium nitride (InN). The GaN-based semiconductor is a semiconductor containing gallium atoms (Ga) and nitrogen atoms (N). Typical examples of the GaN-based semiconductor include GaN, AlGaN, AlGaInN, and InGaN. The semiconductor layer 8 may be a doped type (for example, an n-type including a donor) or a non-doped type. The semiconductor substrate refers to a substrate including a nitride semiconductor (for example, a GaN-based semiconductor), and a material of the main substrate 1 may be a semiconductor or a non-semiconductor. The main substrate 1 and the underlying layer 4 may be collectively referred to as a base substrate, and the main substrate 1, the underlying layer 4, and the mask layer 6 may be collectively referred to as a template substrate 7.

The semiconductor layer 8 is formed by an epitaxial lateral overgrowth (ELO) method starting from the seed portion 3S exposed from the opening portion KS. Thus, the semiconductor layer 8 may be referred to as the ELO semiconductor layer 8. A thickness direction of the semiconductor layer 8 is a Z direction (<0001> direction of a GaN-based crystal). The opening portion KS has a long shape, and its width direction is an X direction (<11-20> direction of the GaN-based crystal).

FIG. 2 is a cross-sectional view illustrating another configuration of the semiconductor substrate according to the present embodiment. As illustrated in FIG. 2, the semiconductor substrate 10 may have a configuration in which the main substrate 1, the underlying layer 4, the mask layer 6, the semiconductor layer 8, and a function layer 9 are provided in that order.

In the semiconductor substrate 10, a plurality of layers are layered on the main substrate, and a layering direction thereof may be defined as an "upward direction". Viewing the semiconductor substrate 10 with a line of sight parallel to a normal direction of the semiconductor substrate 10 may be referred to as a "plan view".

### Main Substrate

A heterogeneous substrate having a lattice constant different from that of a GaN-based semiconductor may be used for the main substrate 1. Examples of the heterogeneous substrate include a silicon (Si) substrate, a sapphire (Al₂O₃) substrate, a silicon carbide (SiC) substrate, and a ScAlMgO₄ substrate. The plane orientation of the main substrate 1 is, for example, the (111) plane of the silicon substrate, the (0001) plane of the sapphire substrate, or the 6H-SiC (0001) plane of the SiC substrate. These are merely examples, and any substrate and any plane orientation may be used as long as the semiconductor layer 8 can be grown by the ELO method. The main substrate may be a free-standing substrate (for example, a wafer cut out from a bulk crystal).

### Underlying Layer

As the underlying layer 4, a buffer layer 2 (for example, an AlN layer) and a seed layer 3 (for example, a GaN-based semiconductor) may be provided in that order from the main substrate side. The buffer layer 2 is a melt suppression layer that can suppress a situation in which the main substrate 1 and the seed layer 3 come into direct contact with each other and melt together. It also has an effect of enhancing the crystallinity of the seed layer 3. The AlN layer is formed using a MOCVD method, for example, to have a thickness of about 10 nm to about 5 µm. For example, when the main substrate 1 unlikely to melt together with the seed layer 3, which is a GaN-based semiconductor, is used, a configuration may be employed in which the buffer layer 2 is not provided. When a silicon substrate or the like is used for the main substrate 1, the main substrate 1 and the GaN-based semiconductor serving as the seed layer melt together. Then, for example, by providing the buffer layer 2 such as an AlN layer, the melting is suppressed.

For example, an AlGaN layer may be used for the seed layer 3. The seed layer 3 includes the seed portion 3S overlapping the opening portion KS of the mask layer 6. As the seed layer 3, a graded layer in which the Al composition approaches GaN in a graded manner may be used. The graded layer is, for example, a laminate body in which an Al_{0.7}Ga_{0.3}N layer as a first layer and an Al_{0.3}Ga_{0.7}N layer as a second layer are provided in that order from the AlN layer side. In this case, the Ga composition ratio (0.7/2 = 0.35) in the second layer (Al : Ga : N = 0.3 : 0.7 : 1) is larger than the GA composition ratio (0.3/2 = 0.15) in the first layer (Al : Ga : N = 0.7 : 0.3 : 1). The graded layer may be easily formed by the MOCVD method and may be composed of three or more layers. By using the graded layer for the seed layer 3, stress from the main substrate 1 as the heterogeneous substrate may be alleviated. The seed layer 3 may have a configuration including a GaN layer. In this case, the seed layer 3 may be a GaN single layer, or the uppermost layer of the graded layer as the seed layer 3 may be a GaN layer. The underlying layer 4 may be composed of only one of the buffer layer 2 and the seed layer 3. Alternatively, a free-standing SiC substrate (for example, a single-crystal wafer cut out from a bulk crystal) may be used as the main substrate 1, and the mask layer 6 may be formed on the SiC substrate to obtain the template substrate without forming the underlying layer.

### Mask Layer

The mask portion 5 and the opening portion KS are formed in the mask layer 6. The opening portion KS exposes the seed layer 3 and has a function of a growth start opening to start the growth of the semiconductor layer 8. The mask portion 5 may have a function of a selective growth mask to cause the semiconductor layer 8 to grow in the lateral direction. The opening portion KS is a portion where the mask portion 5 in the mask layer 6 (mask pattern 6) is not present (no-formation portion), and need not be surrounded by the mask portion 5.

As the mask layer 6, an inorganic insulating film such as a silicon oxide (SiOx) film, a silicon nitride (SiNx) film, a silicon oxynitride film (SiON), a titanium nitride (TiNx) film or the like may be used. For example, a silicon oxide film having a thickness of about 50 nm to about 4 µm (for example, about 100 nm to about 2 µm) is formed on the entire surface of the underlying layer 4 by sputtering, and a resist is applied onto the entire surface of the silicon oxide film. Thereafter, the resist is patterned by photolithography to form the resist having a stripe-shaped opening portion. Thereafter, part of the silicon oxide film is removed by a wet etchant such as hydrofluoric acid (HF), buffered hydrofluoric acid (BHF) or the like to form the opening portion KS, and the resist is removed by organic cleaning to form the mask layer 6 having the opening portion KS and the mask portion 5. The mask portion may be formed on the entire surface of the substrate by photolithography; thereafter, a resist may be applied and patterned, the resist in a region to be the opening portion KS may be removed, and then the opening portion KS may be formed using a dry etching method.

The opening portion KS has a long shape, and a plurality of opening portions KS is periodically arranged with a first period in an a-axis direction (first direction X) of the ELO semiconductor layer 8.

The width of the opening portion KS is about 0.1 µm to 20 µm. As the width of the opening portion KS is smaller, the number of threading dislocations propagating from the opening portion KS to the ELO semiconductor layer 8 is reduced. The ELO semiconductor layer 8 may be easily peeled in a post process. An area of an effective portion with few surface defects may be increased.

For the mask layer 6, a laminate film including the above-described materials, for example, a laminate film including a silicon oxide film and a silicon nitride film may also be used.

### Film Formation of ELO Semiconductor Layer

As the semiconductor layer 8 (ELO semiconductor layer 8), a GaN-based semiconductor layer is formed by the ELO method. The ELO semiconductor layer 8 may be made of GaN, and the seed portion 3S may contain GaN. For example, the template substrate 7 including the main substrate 1, the underlying layer 4, and the mask layer 6 is introduced into an MOCVD device to film-form a GaN layer on the template substrate 7. The following may be adopted as examples of the ELO film formation conditions: substrate temperature: 1120°C, growth pressure: 50 kPa, trimethylgallium (TMG): 22 sccm, NH₃: 15 slm, and V/III = 6000 (ratio of group V raw material supply amount to group III raw material supply amount).

In the film formation of the semiconductor layer 8, interaction between the semiconductor layer 8 and the mask portion 5 is preferably reduced, and a state in which the semiconductor layer 8 and the mask portion 5 are in contact with each other by van der Waals force is preferably maintained. That is, the semiconductor layer 8 and the mask portion 5 are in contact with each other mainly by van der Waals force.

The adjacent ELO semiconductor layers 8 respectively grown from the adjacent opening portions KS may meet each other, or may form a gap near the center of the mask portion 5 by not meeting each other. When meeting each other, the entire surface of the substrate may form a flat surface. When not meeting each other, stress (compressive stress or tensile stress) generated when the main substrate 1 mainly composed of a material different from the nitride semiconductor is used may be more effectively alleviated by the gap, thus the occurrence of defects, cracks, and the like may be effectively suppressed.

### Shape of ELO Semiconductor Layer

The semiconductor layer 8 includes an effective portion YS (a portion to constitute an element portion in the post process) located between the opening portion KS and a center 5C of the mask portion in a plan view. A portion of the semiconductor layer 8 located over the seed portion 3S (a portion having many threading dislocations) is a non-effective portion NS. That is, the semiconductor layer 8 includes the effective portion YS having a relatively small number of threading dislocations and the non-effective portion NS having a relatively large number of threading dislocations. The non-effective portion NS is a dislocation successive portion and has more threading dislocations than the effective portion YS (dislocation non-successive portion), but may be used as part of the device. For example, when the function layer 9 includes an active layer, a portion (light emitting portion) of the active layer where electrons and positive holes are combined may be provided to overlap the effective portion YS in a plan view. An N-type electrode (cathode) or the like may be provided to overlap the non-effective portion NS in a plan view.

The threading dislocation is a dislocation (defect) extending from the lower surface or inside of the semiconductor layer 8 to the surface or surface layer thereof along the thickness direction (<0001> direction, Z direction) of the ELO semiconductor layer 8. The threading dislocation may be observed by performing cathode luminescence (CL) measurement on the surface (parallel to a c-plane) of the semiconductor layer 8.

The semiconductor layer 8 in FIG. 1 has an edge face (side surface) 8E near the center of the mask portion 5, and does not meet the semiconductor layer 8 grown from the adjacent seed portion 3S. When the c-plane ELO semiconductor layer 8 is formed in an island shape, the side surface of the ELO semiconductor layer 8 is typically formed by a <1-10α> plane (α is any integer), a <11-2β> plane (β is any integer), or a plane crystallographically equivalent to these planes. That is, the edge face 8E of the semiconductor layer 8 may have an oblique surface (facet).

As described above, the semiconductor layers 8 laterally grown in opposite directions from the two adjacent seed portions 3S do not make contact with (do not meet) each other on the mask portion 5 but have a gap GP, thereby making it possible to reduce an internal stress in the semiconductor layer 8. With this, cracks and defects that may be produced in the semiconductor layer 8 can be decreased. This effect is particularly exhibited in the present embodiment in which the main substrate 1 is a heterogeneous substrate. The width of the gap GP is preferably 4 µm or less, and more preferably 3 µm or less.

The semiconductor layer 8 may be an n-type GaN-based semiconductor (silicon is a donor, for example). When forming the function layer 9 including, for example, a p-type semiconductor layer above the semiconductor layer 8 (see FIG. 2), in a case where the semiconductor layer 8 contains silicon, oxygen, or the like as n-type dopant, p-type dopant (magnesium or the like) may be supplied in compensation. However, this phenomenon may be significantly reduced by suppressing the width of the gap GP to the above-described range.

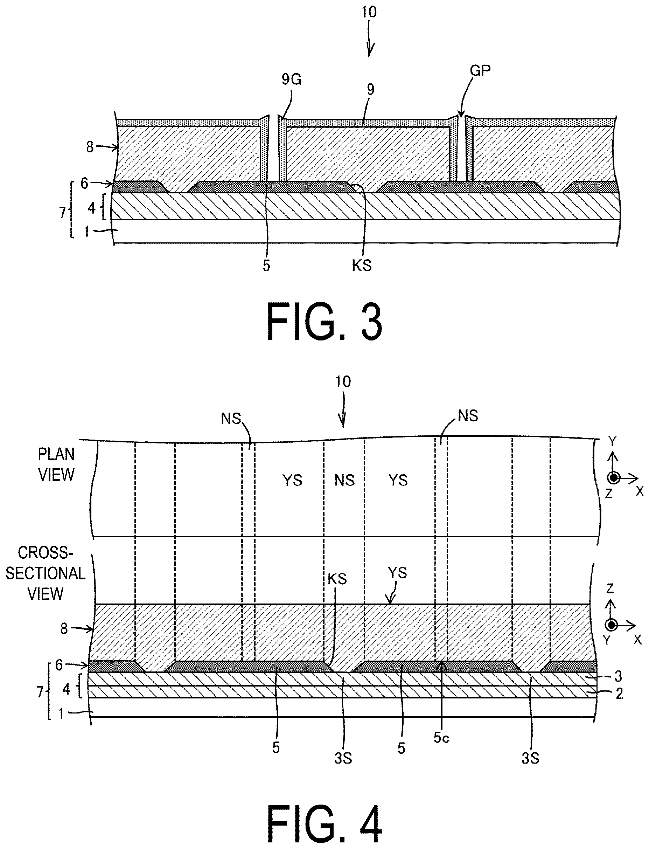

FIG. 3 is a cross-sectional view illustrating another configuration of the semiconductor substrate according to the present embodiment. When the function layer 9 is formed, an edge growth 9G (corner portion) may be generated as depicted in FIG. 3. The edge growth is generated when the function layer 9 includes an AlGaN layer, for example. The edge growth may have a width of 10 µm or more and a height of about 200 nm to about 300 nm, and becomes an obstacle in the post process. However, by suppressing the width of the gap GP to the range described above, the edge growth 9G may be significantly reduced (for example, to 100 nm or less).

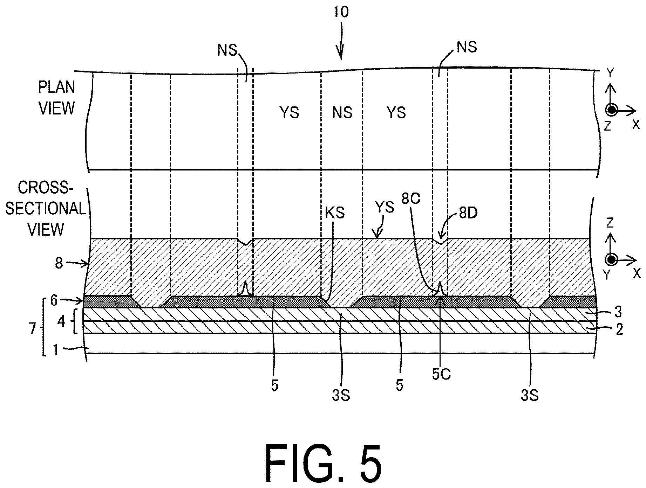

FIG. 4 and FIG. 5 each include a plan view and a cross-sectional view illustrating another configuration of the semiconductor substrate according to the present embodiment. The semiconductor layer 8 in FIG. 4 has a configuration in which the semiconductor layers laterally grown in opposite directions from the two adjacent seed portions 3S meet each other near the center 5C of the mask portion and are integrated with each other. In this configuration, as illustrated in FIG. 5, a hollow portion 8C may be formed near the center 5C of the mask portion, which is a meeting point, by appropriately setting the film formation conditions of the ELO semiconductor layer 8, the width of the mask portions 5, and the like. The shape of the hollow portion 8C is a shape that becomes wider on the mask portion 5 side (for example, a spindle shape or a drop shape in a cross-sectional view). In this case, the semiconductor layer 8 includes a portion (non-effective portion NS) overlapping the hollow portion 8C in a plan view. That is, the semiconductor layer 8 includes the effective portion YS and the non-effective portion NS adjacent to the effective portion YS.

Since silicon oxide, silicon nitride, and a silicon oxynitride film used as the material of the mask layer 6 have a smaller thermal expansion coefficient than the GaN-based semiconductor, when the ELO semiconductor layer 8 having been assembled at about 1000°C is cooled to room temperature, cracks may occur in the ELO semiconductor layer 8 due to a difference in thermal expansion coefficient. Since the hollow portion 8C has an effect of significantly reducing the internal stress of the semiconductor layer 8, the occurrence of such cracks may be effectively reduced. The surface of the semiconductor layer 8 may have a depression 8D at a portion corresponding to an upper portion of the hollow portion 8C. The depression 8D also has an effect of alleviating the internal stress of the semiconductor layer 8.

### Function Layer

The semiconductor substrate 10 in FIG. 2 includes the function layer 9 on the semiconductor layer 8. The function layer 9 includes, for example, at least one selected from the group consisting of a GaN-based n-type semiconductor layer, a GaN-based non-doped semiconductor layer, a GaN-based p-type semiconductor layer, an electrically conductive layer, and an insulation layer. The GaN-based semiconductor layer of the function layer 9 may be formed by any film formation method. The function layer 9 may be a compound semiconductor layer (compound semiconductor part). The compound semiconductor layer may be a nitride semiconductor layer (nitride semiconductor part). In this case, the nitride semiconductor layer may include a p-type layer and an active layer (for example, a light emitting layer), or may include an n-type layer, an active layer, and a p-type layer.

The function layer 9 may constitute a semiconductor device (for example, an LED or a laser) together with the semiconductor layer 8, but is not limited thereto. For example, only a GaN-based n-type semiconductor layer may be provided.

### Element Separation on Semiconductor Substrate

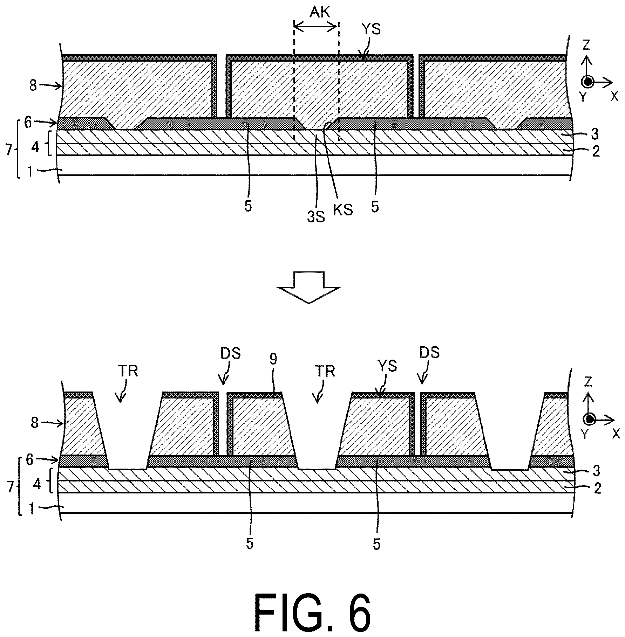

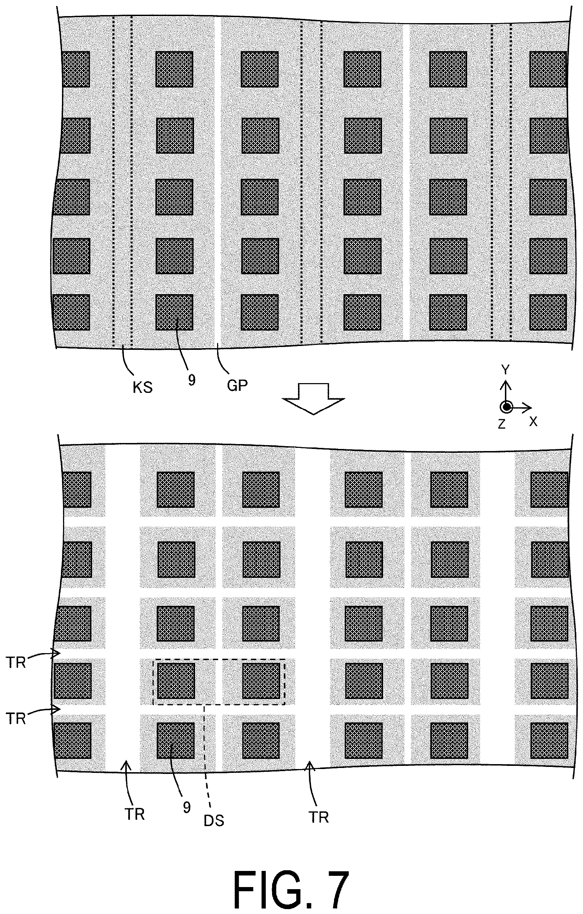

FIG. 6 is a cross-sectional view illustrating an element separation step according to the present embodiment. FIG. 7 is a plan view illustrating the element separation step according to the present embodiment. As illustrated in FIG. 6, a region AK overlapping the opening portion KS in a plan view in the semiconductor substrate 10 is removed by gas phase etching until the underlying layer 4 is reached.

In this case, part of each of the underlying layer 4, mask layer 6, semiconductor layer 8, and function layer 9 is a target to be removed, and the underlying layer 4 and mask portion 5 are exposed in a trench TR (element separation trench) formed after the removal. The opening width of the trench TR is desirably larger than the width of the opening portion KS of the mask layer. An element portion DS may be separated in the semiconductor substrate 10 by the element separation step. At this stage, the element portion DS is bonded to the mask portion 5 of the template substrate by van der Waals bonding, and is part of the semiconductor substrate 10.

As illustrated in FIG. 7, the trench TR may be formed in a lattice shape (lattice pattern) in a plan view. In this case, a region surrounded by adjacent lateral trenches (extending in the X direction) and adjacent longitudinal trenches (extending in a Y direction) may include one element portion DS.

The gas phase etching is implemented by a general photolithography method. After completion of the etching, the photoresist having served as the mask for the gas phase etching needs to be removed. When organic cleaning using weak ultrasonic waves is carried out, the element portion DS is unlikely to be peeled off from the mask portion 5.

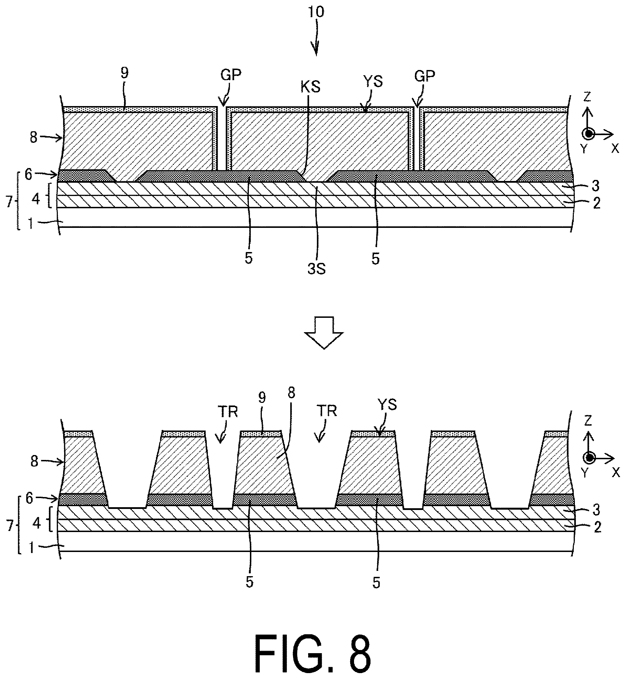

FIG. 8 is a cross-sectional view illustrating another example of the element separation step. As illustrated in FIG. 8, a region overlapping the opening portion KS and a region overlapping the gap portion GP in a plan view in the semiconductor substrate 10 may be removed by gas phase etching until the underlying layer 4 is reached. By doing so, the meandering of the semiconductor layer 8 in a second direction (the longitudinal direction of the opening portion KS, the Y direction) is eliminated, and the element portion DS having a uniform shape may be obtained.

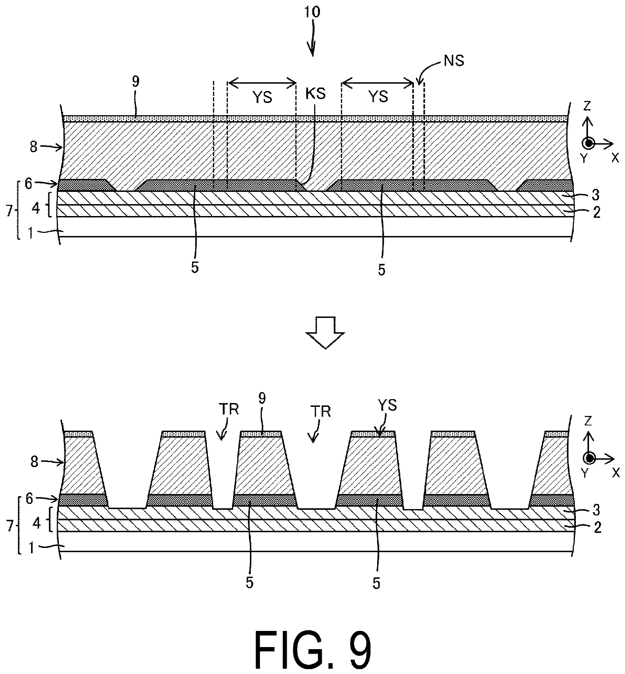

FIG. 9 is a cross-sectional view illustrating another example of the element separation step. As illustrated in FIG. 9, a region overlapping the opening portion KS and a region overlapping a center portion of the mask portion 5 (non-effective portion NS) in a plan view in the semiconductor substrate 10 may be removed by gas phase etching until the underlying layer 4 is reached.

### Element Peeling from Template Substrate

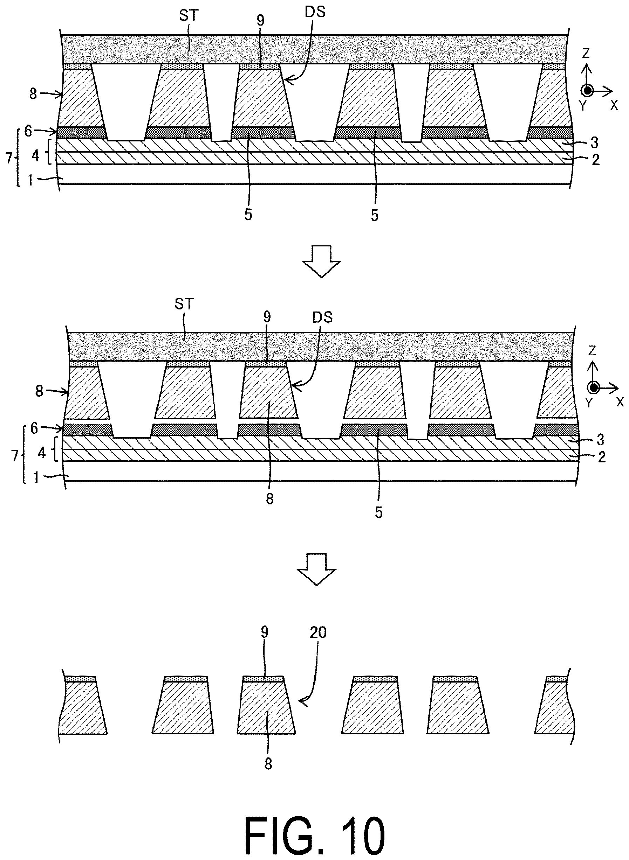

FIG. 10 is a cross-sectional view illustrating an element peeling step. Since the semiconductor layer 8 and the mask portion 5 are bonded to each other by van der Waals force (weak force), by pulling up the function layer 9 with attractive force (adhesive force, suction force, electrostatic force, or the like) of a stamp device ST or the like, the element portion DS may be easily peeled off from the template substrate to obtain the semiconductor device 20, as illustrated in FIG. 10. Direct peeling from the mask portion 5 can be carried out using a viscoelastic elastomer stamp, an electrostatic adhesion stamp, or the like, which brings a large advantage in terms of cost, throughput, and the like. However, when adhesion is present between the mask portion 5 and the semiconductor layer 8, peeling becomes difficult to carry out. Because of this, reducing such adhesion is of large significance (described later). After the viscoelastic elastomer stamp, the electrostatic adhesion stamp or the like is brought into contact with the semiconductor layer 8, for example, vibrations by ultrasonic waves may be applied. With vibrations or the like, the semiconductor layer 8 may be more easily peeled off from the mask portion 5.

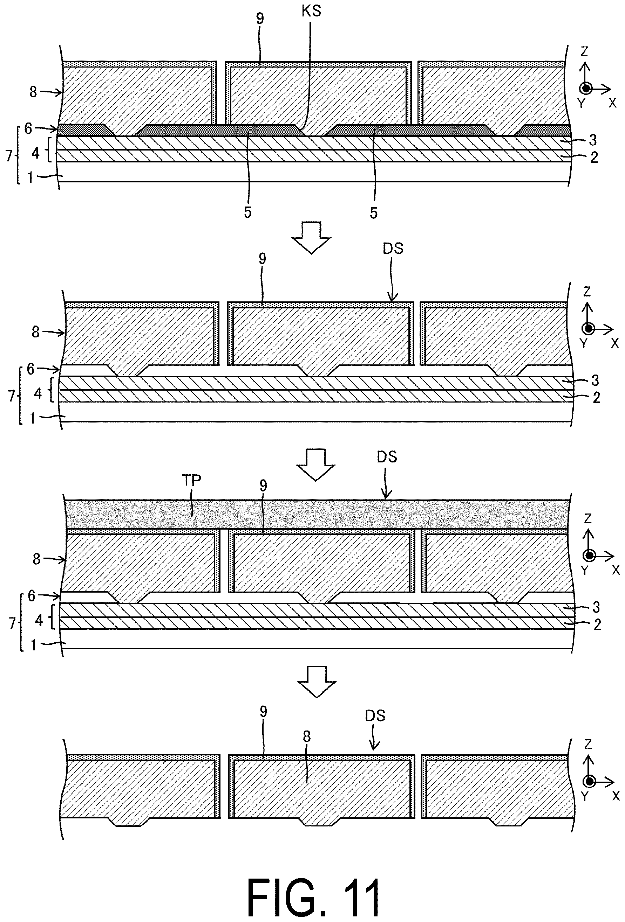

FIG. 11 is a cross-sectional view illustrating another example of the element peeling step. As illustrated in FIG. 11, after the mask portion 5 is wet-etched and the element portion DS of the semiconductor layer 8 is connected only to the seed layer 3, the element portion DS may be mechanically peeled off from the template substrate 7 with a tape TP or the like. In this case, since the upper side of the opening portion KS is not required to be etched, the semiconductor device 20 having a large size may be formed. This peeling method has an advantage in that the element separation step may be omitted when the semiconductor layer 8 is of a separation type (when an edge face is present on the mask portion). When the semiconductor layer 8 is of an integrated type (when an edge face is not present on the mask portion), there is an advantage that the element peeling is easy to carry out because only a dug portion for inflow of an etchant is required to be formed (down to the underlying layer).

### Semiconductor Device

As illustrated in FIGs. 10 and 11, the element portion DS peeled off from the template substrate 7 functions as the semiconductor device 20. Specific examples of the semiconductor device 20 include a light-emitting diode (LED), a semiconductor laser, a Schottky diode, a photodiode, and a transistor (including a power transistor and a high electron mobility transistor).

### Electronic Device

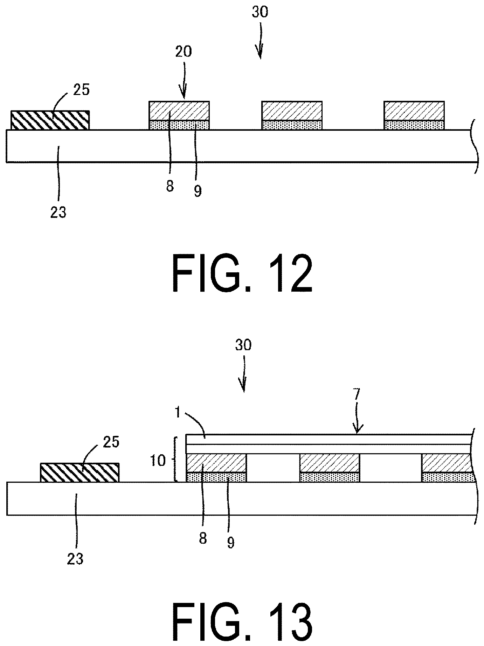

FIG. 12 is a schematic view illustrating a configuration of an electronic device according to the present embodiment. An electronic device 30 in FIG. 12 includes the semiconductor device 20 including the semiconductor layer 8 and the function layer 9, a drive substrate 23, on which the semiconductor device 20 is mounted, and a control circuit 25 configured to control the drive substrate 23. FIG. 13 is a schematic view illustrating another configuration of the electronic device according to the present embodiment. The electronic device 30 in FIG. 13 includes the semiconductor substrate 10 including the semiconductor layer 8 and the function layer 9, the drive substrate 23, on which the semiconductor substrate 10 is mounted, and the control circuit 25 configured to control the drive substrate 23. In this case, the main substrate 1 may be a light-transmissive substrate (for example, a sapphire substrate).

Examples of the electronic device include a display device, a laser emitting device (including a Fabry-Perot type and a surface emitting type), a measurement device, an illumination device, a communication apparatus, an information processing apparatus, and a power control device.

### Void in ELO Semiconductor Layer Back Surface

Hereinafter, the back surface of the ELO semiconductor layer 8 in the semiconductor substrate 10 (boundary surface with the mask portion 5) will be described.

When a heterogeneous substrate is used and the mask portion 5 has a large width, a void may be generated in the back surface of the ELO semiconductor layer 8. This void becomes a cause of a surface defect of the ELO semiconductor layer 8 (for example, a start point of a defect when stress is applied to the semiconductor layer 8), and brings about degradation in characteristics and a decrease in the reliability of the device formed on the ELO semiconductor layer 8. In the present embodiment, by increasing the lateral film-formation rate and reducing the interaction between the ELO semiconductor layer 8 and the mask portion 5, the surface morphology of the mask portion 5 was improved, and consequently, the voids in the back surface of the ELO semiconductor layer 8 and the adhesion with the mask portion 5 were successfully reduced.

Specifically, in order to reduce the deterioration of the mask portion 5, the lateral film-formation rate is increased to quickly cover the mask portion 5 with the lateral growth film (ELO semiconductor layer 8). This is because, in the MOCVD, when the lateral film-formation rate is low, the mask portion 5 is exposed to hydrogen and nitrogen at a high temperature for a long time, and evaporation and decomposition of the mask portion 5 proceed, which may bring about deterioration in the surface morphology, generation of pin holes, generation of pits, and the like.

A method for increasing the lateral film-formation rate is as follows. First, a longitudinal growth layer that grows in a c-axis direction is formed on the seed portion exposed from the opening portion KS of the mask layer 6, and then a lateral growth layer that grows in the a-axis direction is formed thereon. In this case, by setting the thickness of the longitudinal growth layer to be 10 µm or less, preferably 5 µm or less, and more preferably 3 µm or less, the thickness of the lateral growth layer may be suppressed to be thin and the lateral film-formation rate may be increased.

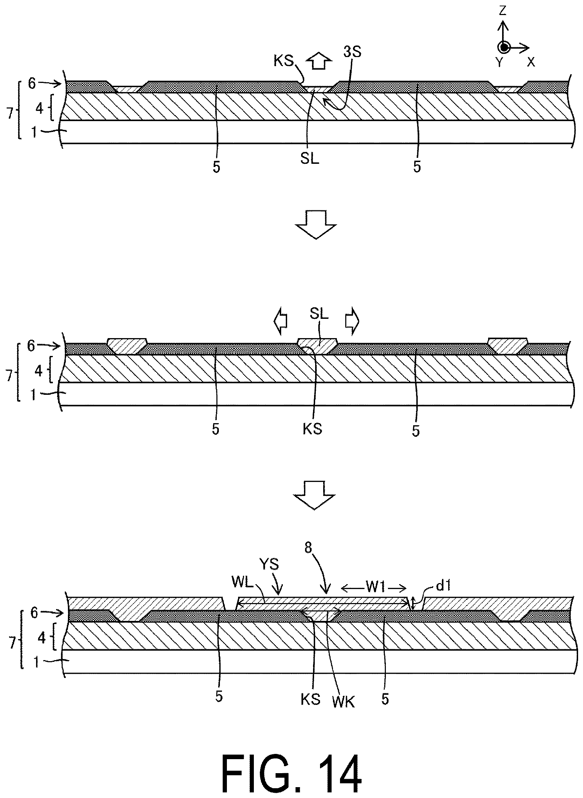

FIG. 14 is a cross-sectional view illustrating an example of a lateral growth of a semiconductor layer. As illustrated in FIG. 14, an initial growth layer SL is formed on the seed portion 3S overlapping the opening portion KS, and then the semiconductor layer 8 is desirably grown laterally from the initial growth layer SL. The initial growth layer SL serves as a start point of the lateral growth of the semiconductor layer 8. In the film formation of the semiconductor layer 8, the film formation of the initial growth layer SL is preferably stopped at a timing immediately before an edge of the initial growth layer SL rides on the upper surface of the mask portion 5 (at a stage of being in contact with the upper end of a side surface of the mask portion 5) or immediately after the edge of the initial growth layer SL rides on the upper surface of the mask portion 5 (that is, at this timing, the ELO film formation condition is switched from the c-axis direction film-formation condition to the a-axis direction film-formation condition). With this, since the lateral film formation is performed from a state where the initial growth layer SL slightly protrudes from the mask portion 5, consumption of the material for the growth of the semiconductor layer 8 in the thickness direction may be reduced, and the semiconductor layer 8 may be effectively grown in the lateral direction at a high speed. The initial growth layer SL may be formed to have a thickness of 50 nm to 5.0 µm (for example, 80 nm to 2 µm). The thickness of the initial growth layer SL may be equal to or less than 500 nm.

By laterally growing the semiconductor layer 8 after film-forming the initial growth layer SL as illustrated in FIG. 14, the number of non-threading dislocations inside the effective portion YS may be increased (the threading dislocation density on the surface of the effective portion YS may be lowered). The distribution of the impurity concentration (for example, silicon or oxygen) inside the effective portion YS may be controlled. The semiconductor layer 8 may be controlled to grow in the Z direction (c-axis direction) or in the X direction (a-axis direction) by appropriately controlling the conditions during the film formation of the semiconductor layer 8.

Regarding the effective portion YS of the semiconductor layer 8 depicted in FIG. 14, the ratio of a size W1 in the X direction (first direction) to a thickness d1 (W1/d1) may be set to 2.0 or more, for example. Using the technique of FIG. 14 makes it possible to set W11d1 to 1.5 or more, 2.0 or more, 4.0 or more, 5.0 or more, 7.0 or more, or 10.0 or more. It has been found that the dividing step as illustrated in FIG. 7 is facilitated by setting W11d1 to 1.5 or more. The internal stress of the semiconductor layer 8 is reduced and the substrate warp is reduced. The aspect ratio of the semiconductor layer 8 (the ratio of a size in the X direction to the thickness = WL/d1) may be set to 3.5 or more, 5.0 or more, 6.0 or more, 8.0 or more, 10 or more, 15 or more, 20 or more, 30 or more, or 50 or more. Using the technique of FIG. 14 makes it possible to set the ratio of the size WL in the X direction of the semiconductor layer 8 to a width WK of the opening portion KS (WL/WK) to 3.5 or more, 5.0 or more, 6.0 or more, 8.0 or more, 10 or more, 15 or more, 20 or more, 30 or more, or 50 or more, and makes it possible to raise the ratio of the effective portion. The semiconductor layer 8 depicted in FIG. 14 may be a nitride semiconductor crystal (for example, a GaN crystal, an AlGaN crystal, an InGaN crystal, or an InAlGaN crystal).

The non-threading dislocation is a dislocation observed by CL in a cross section taken along a plane parallel to the c-axis (a plane parallel to the thickness direction), and is mainly a basal plane (c-plane) dislocation. The plane parallel to the c-axis may be a plane parallel to the (1-100) plane (a plane whose normal line extends in the Y direction) or may be a plane parallel to the (11-20) plane (a plane whose normal line extends in the X direction).

The non-threading dislocation density in the effective portion YS of the semiconductor layer 8 is higher than the threading dislocation density in the effective portion YS. In other words, the effective portion YS of the semiconductor layer 8 may be expressed as a GaN-based crystal body (GaN-based layer) in which the non-threading dislocation density is larger than the threading dislocation density. In this case, the non-threading dislocation density may be 10 times or more, for example, 20 times or more the threading dislocation density. The threading dislocation density may be, for example, 5 × 10⁶ [pieces/cm²] or less. The width (length in the X direction) of the effective portion (GaN-based crystal body) may be, for example, 10 µm or more. The effective portion (GaN-based crystal body) may have a long shape in which the size in the Y direction (m-axis direction) is larger than the size in the X direction (a-axis direction). Regarding the effective portion (GaN-based crystal body), the non-threading dislocation density in a cross section taken along a plane parallel to the (11-20) plane may be larger than the non-threading dislocation density in a cross section taken along a plane parallel to the (1-100) plane. Since the effective portion (GaN-based crystal body) is formed by the lateral (X direction) growth, the concentration of impurities (atoms contained in the mask layer 6, for example, silicon or oxygen) may be low, as compared with one end portion corresponding to the growth initial stage, at the other end portion corresponding to the growth termination stage in the X direction.

The quality (thickness uniformity, film quality, and the like) of the mask portion 5 is affected by the surface flatness, crystallinity, and material of the underlying layer on which the mask portion 5 is formed. When a defective portion is present in the underlying layer, a reaction between the mask portion 5 and the underlying layer proceeds from the defective portion, thus the quality of the mask portion 5 is deteriorated. As a result, a reaction between the mask portion 5 and the ELO semiconductor layer 8 formed on the mask portion 5 is accelerated, and a void may be generated in the back surface of the ELO semiconductor (the boundary surface with the mask portion 5). In the ELO method, since film formation proceeds from both sides of the mask portion 5 toward the center, the void is likely to be formed in a portion close to the center (a portion where the time until film formation is implemented is long).

A film-forming temperature of the ELO semiconductor layer 8 is preferably 1150°C or less rather than a high temperature exceeding 1200°C. The ELO semiconductor layer 8 may be formed even at a low temperature below 1000°C, which is more preferable from the viewpoint of reducing the interaction. It has been found that in such low-temperature film formation, when trimethyl gallium (TMG) is used as a gallium raw material, the raw material is not sufficiently decomposed, and gallium atoms and carbon atoms are simultaneously taken into the ELO semiconductor layer 8 in larger quantities than usual. The reason for this may be as follows: in the ELO method, since the film formation in the a-axis direction is fast and the film formation in the c-axis direction is slow, the above atoms are taken in during the c-plane film formation in large quantities.

It has been known that the carbon taken into the ELO semiconductor film reduces the reaction with the mask portion 5, reduces the interaction with the mask portion 5, and does not cause adhesion with the mask portion or the like 5. Thus, in the low-temperature film formation of the ELO semiconductor layer 8, the supply amount of ammonia is reduced and the film formation is performed at a substantially low V/III (< 1000), thereby making it possible to take the carbon elements in the raw material or a chamber atmosphere into the ELO semiconductor layer 8 and reduce the reaction with the mask portion 5. In this case, the semiconductor layer 8 contains carbon.

In the low-temperature film formation at a temperature below 1000°C, triethylgallium (TEG) is preferably used as a gallium raw material gas. Since an organic raw material is efficiently decomposed at a low temperature with TEG as compared with TMG, the lateral film-formation rate may be increased.

An InGaN layer may be formed as the ELO semiconductor layer 8. The lateral film formation of the InGaN layer is carried out at a low temperature below 1000°C, for example. This is because the vapor pressure of indium increases at a high temperature and indium is not effectively taken into the film. When the film-forming temperature is low, an effect is exhibited in which the interaction between the mask portion 5 and the InGaN layer is reduced. The InGaN layer has an effect of exhibiting lower reactivity with the mask portion 5 than the GaN layer. When indium is taken into the InGaN layer at an In composition level of 1% or more, the reactivity with the mask portion 5 is further lowered, which is desirable. As the gallium raw material gas, triethylgallium (TEG) is preferably used.

Since the interaction between the mask portion 5 and the ELO semiconductor layer 8 is brought about by various factors in combination, the above-mentioned measures may be combined.

By suppressing the generation of voids in the back surface of the ELO semiconductor layer 8, line defects in the surface (surface layer) of the ELO semiconductor layer 8 may be reduced. An m-plane of the ELO semiconductor layer 8 is vulnerable to stress, and therefore defects are likely to be generated. The line defects are assumed to have been generated due to a crystal slip along the m-plane. In a specific cross section parallel to the c-plane, a dislocation extending in the m-axis direction (assumed to be a mixed dislocation in which an edge dislocation and a screw dislocation are combined) may be observed as a line defect. However, such a case is acceptable when the line defect disappears (is not observed) in a cross section (parallel to the c-plane) cut at a surface layer rather than this specific cross section.

### Adhesion on ELO Semiconductor Layer Back Surface

When a heterogeneous substrate is used and the mask portion 5 has a large width, adhesion with the mask portion 5 may occur on the back surface of the ELO semiconductor layer 8. When such adhesion exists, the stress generated due to a difference in the thermal expansion coefficient between the ELO semiconductor layer 8 and the heterogeneous substrate is hard to be alleviated, thereby causing a surface defect. When the ELO semiconductor layer 8 is peeled from the template substrate 7, the peeling yield is lowered.

In the present embodiment, by reducing the interaction between the ELO semiconductor layer 8 and the mask portion 5, the adhesion between the ELO semiconductor layer 8 and the mask portion 5 is reduced. Specifically, the material and thickness of the mask portion 5 are optimized, and the film density of the mask portion 5 is increased. When the film density of the mask portion 5 is low, the evaporation of the film is early or the etching rate is high with respect to the film formation at a high temperature in a hydrogen atmosphere in the MOCVD device. When the mask portion 5 such as that described above is covered with the laterally growing ELO semiconductor layer 8, the mask portion 5 and the ELO semiconductor layer 8 adhere to each other. The reason for this is assumed to be as follows: a reaction layer in which the mask portion 5 and the ELO semiconductor layer 8 are mixed is generated and the ELO semiconductor layer 8 is fixed to the mask portion 5.

When the ELO semiconductor layer 8 and the mask portion 5 are fixed to each other, an intermediate layer (a layer in which the mask portion 5 and the semiconductor layer 8 react with each other or are mixed with each other) is formed on the back surface of the ELO semiconductor layer 8. This intermediate layer (adhesion layer) is not removed even when the mask portion 5 is removed using an etchant such as hydrofluoric acid, but remains on the back surface of the ELO semiconductor layer 8. Because of this, when the intermediate layer is formed, the surface morphology of the back surface of the ELO semiconductor layer 8 after being peeled from the template substrate 7 is deteriorated. The influence of the adhesion is small when an arithmetic mean surface roughness Ra measured with an atomic force microscope (AFM) is less than or equal to 10 nm, and preferably about 1 nm. The influence of the adhesion was large when Ra was about 13 nm. By measuring the surface roughness of the back surface of the ELO semiconductor layer 8 with the AFM using a peeling method described below (see Example 1), the state of adhesion and the like may be recognized.

### Preferred Configuration of Mask Layer

As the mask layer, in addition to the above-described silicon oxide film (SiOₓ), a single-layer film made of any one of a titanium nitride film (TiN or the like), a silicon nitride film (SiN or the like), a silicon oxynitride film (SiON) and a high melting point metal film, or a multi-layer film made of two or more of the aforementioned may be cited.

The mask portion 5 may be a silicon nitride film or a silicon oxynitride film. The silicon oxide film is decomposed and evaporated in a small amount during the formation of the ELO semiconductor layer 8 and may be taken into the ELO semiconductor layer 8, but the silicon nitride film and the silicon oxynitride film have an advantage in terms of hardly decomposing and evaporating at a high temperature. Even when a general silicon oxide film is used for the mask layer in the ELO method, the interaction between the mask portion 5 and the ELO semiconductor layer 8 may be effectively reduced by optimizing the film formation conditions of the mask layer and the ELO semiconductor layer 8.

Thus, the mask layer may be a single-layer film of a silicon nitride film or a silicon oxynitride film, a multi-layer film in which a silicon oxide film and a silicon nitride film are formed in that order on the underlying layer, a multi-layer film in which a silicon nitride film and a silicon oxide film are formed in that order on the underlying layer, or a multi-layer film in which a silicon nitride film, a silicon oxide film, and a silicon nitride film are formed in that order on the underlying layer.

An abnormal portion such as a pinhole in the mask portion 5 may be eliminated by performing organic cleaning or the like after film formation and introducing the film again into a film forming device to form the same type of film. A high-quality mask layer may be formed by using a general silicon oxide film and using the above-described mask reformation method.

### Evaluation of Present Semiconductor Substrate

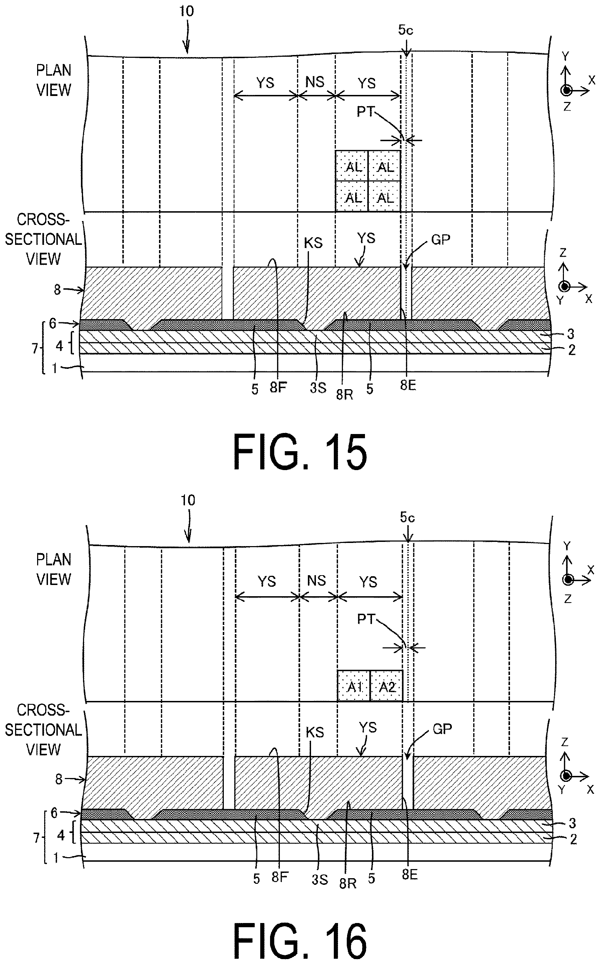

Hereinafter, evaluation of the semiconductor substrate 10 will be described. FIG. 15 to FIG. 18 each include a plan view and a schematic view illustrating evaluation of the present semiconductor substrate (a configuration in which the ELO semiconductor layer has an edge face on the mask). The back surface of the semiconductor layer 8 (a boundary surface 8R with the mask portion) may be evaluated in a state of being a boundary surface in contact with the mask portion 5, or the semiconductor layer 8 is peeled from the mask portion 5 and the peeled surface may also be evaluated. In this case, the semiconductor layer 8 may be peeled by removing the mask portion 5 by wet etching or the like (note that when the semiconductor layer 8 is of an integrated type, digging may be performed in advance until the underlying layer 4 is reached).

The surface of the ELO semiconductor layer 8 in the semiconductor substrate 10 was measured by the cathode luminescence (CL) method. As a result, an upper surface 8F of the effective portion YS included at least one low-level defective region AL having a size of 10 µm in the first direction X (a-axis direction) along the width direction of the opening portion KS and 10 µm in the second direction Y (m-axis direction) orthogonal to the first direction, and no line defect (line defect oblique with respect to the first direction X assumed to have been brought about by an m-plane slip) was measured in the low-level defective region AL (see FIG. 15, evaluation criterion 1). More specifically, the upper surface of the effective portion YS included the plurality of low-level defective regions AL arranged in the first direction X and the plurality of low-level defective regions AL arranged in the second direction Y (see FIG. 15, evaluation criterion 2). The size in the first direction of the effective portion YS was larger than the width of the opening portion KS (see FIG. 15, evaluation criterion 3).

The effective portion YS included, at the boundary surface 8R with the mask portion 5, a first region A1 having a size of 10 µm in the first direction X and 10 µm in the second direction Y, and a second region A2 having the same size as that of the first region A1, located closer to the center side of the mask portion 5 than the first region A1, and having an interval PT with the center 5C of the mask portion 5, the interval PT being 30% or less the width of the mask portion 5. Then, the effective portion YS was peeled from the mask portion 5 and the first region A1 and the second region A2 were observed with the AFM. As a result, the number of recessed portions having a major axis of 0.1 [µm] or more in the first region A1 was equal to or less than the number of recessed portions having a major axis of 0.1 µm or more in the second region A2 (see FIG. 16, evaluation criterion 4). The major axis of the recessed portions present in the first region A1 was 1 µm or less (hereinafter, evaluation criterion 5).

Regarding the effective portion YS before being peeled from the mask portion 5, cross sections of the first region A1 and the second region A2 were observed with the AFM. As a result, the number of voids having a major axis of 0.1 µm or more in the first region A1 was equal to or less than the number of voids having a major axis of 0.1 µm or more in the second region A2 (see FIG. 16, evaluation criterion 6).

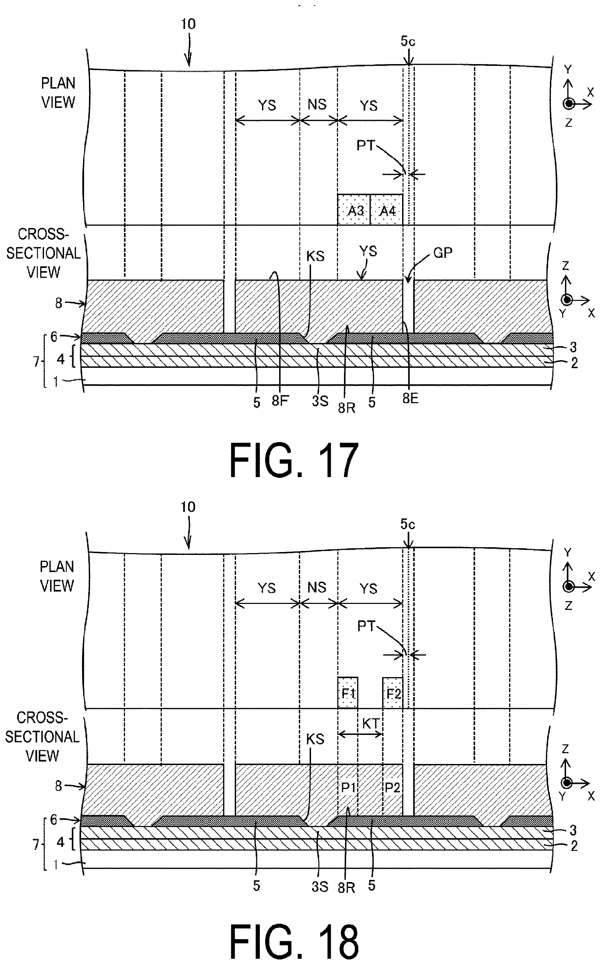

The effective portion YS included, at the boundary surface 8R with the mask portion 5, a third region A3 having a size of 10 µm in the first direction X and 10 µm in the second direction Y, and a fourth region A4 having the same size as that of the third region A3 and located closer to the center side of the mask portion 5 than the third region A3. Then, the effective portion YS was peeled from the mask portion 5 and the first region A3 and the second region A4 were observed with the AFM. As a result, an adhesion area in the third region A3 was smaller than an adhesion area in the fourth region A4 (see FIG. 17, evaluation criterion 7). The third region A3 was a non-adhesion region in which adhesion with the mask portion 5 was not substantially observed (hereinafter, evaluation criterion 8). The fourth region A4 was located at a position where the interval PT between the fourth region A4 and the center 5C of the mask portion was 30% or less the width of the mask portion 5.

The effective portion YS included a first portion P1 and a second portion P2 farther from the opening portion KS than the first portion P1 and having an interval KT of 10 µm or more with the opening portion KS. Due to the surface roughness (Ra) of a peeled surface F1 when the first portion P1 was peeled from the mask portion 5 being defined as a first surface roughness, and the surface roughness (Ra) of a peeled surface F2 when the second portion P2 was peeled from the mask portion 5 being defined as a second surface roughness, the first surface roughness was equal to or less than the second surface roughness (see FIG. 18, evaluation criterion 9). In this case, when part of the roughness curve measured by the AFM is extracted at a standard length, the arithmetic mean roughness (Ra) in a range of 5 µm × 5 µm of each peeled surface may be represented by the mean value of an unevenness state in the extracted section. The value of the ratio of the second surface roughness to the first surface roughness was 1.0 to 10 (evaluation criterion 10). The peeled surfaces (including F1 and F2) obtained when the effective portion YS was peeled from the mask portion 5 included a flat region having a size of 10 µm in the first direction and 10 µm in the second direction and having no recessed portion with a major axis of 0.1 µm or more (evaluation criterion 11). The second surface roughness was less than 10 nm (evaluation criterion 12). In a plan view, the first portion P1 was adjacent to the opening portion KS, and the interval PT between the second portion P2 and the center 5C of the mask portion was 30% or less the width of the mask portion 5 (evaluation criterion 13). When such an area ratio that the recessed portions with a major axis of 0.1 µm or more included in the peeled surface F1 of the first portion P1 occupied the peeled surface was defined as a first recessed portion occupancy ratio, and such an area ratio that the recessed portions with a major axis of 0.1 µm or more included in the peeled surface F2 of the second portion occupied the peeled surface was defined as a second recessed portion occupancy ratio, the first recessed portion occupancy ratio was equal to or less than the second recessed portion occupancy ratio (evaluation criterion 14). In this case, the recessed portions (void regions) are measured with the AFM in a range of 5 µm × 5 µm of each peeled surface, thereby making it possible to obtain the major axes, occupancy ratios, and the like.

The impurity concentration in the peeled surface F1 of the first portion P1 was higher than the impurity concentration in the peeled surface F2 of the second portion P2 (evaluation criterion 15).

The threading dislocation density in the upper surface 8R of the effective portion YS was 5 × 10⁶ [pieces/cm²] or less (evaluation criterion 16).

As described above, important factors to decrease the surface defects of the semiconductor layer 8 are a reduction in adhesion with the mask portion 5, thereby alleviating stress, and a reduction in the generation of voids that may cause surface defects (m-plane slip).

The crystallinity of the ELO semiconductor layer 8 laterally grown on the mask 5 from the opening portion KS of the mask 5 is significantly high. In the semiconductor substrate 10, by reducing the interaction between the mask portion 5 and the semiconductor layer 8, voids and adhesion generated in the back surface of the semiconductor layer 8 are decreased and the stress from the main substrate 1 is effectively alleviated. This indicates that the defect generated in the effective portion YS does not penetrate to the surface of the semiconductor layer 8 but is confined therein.

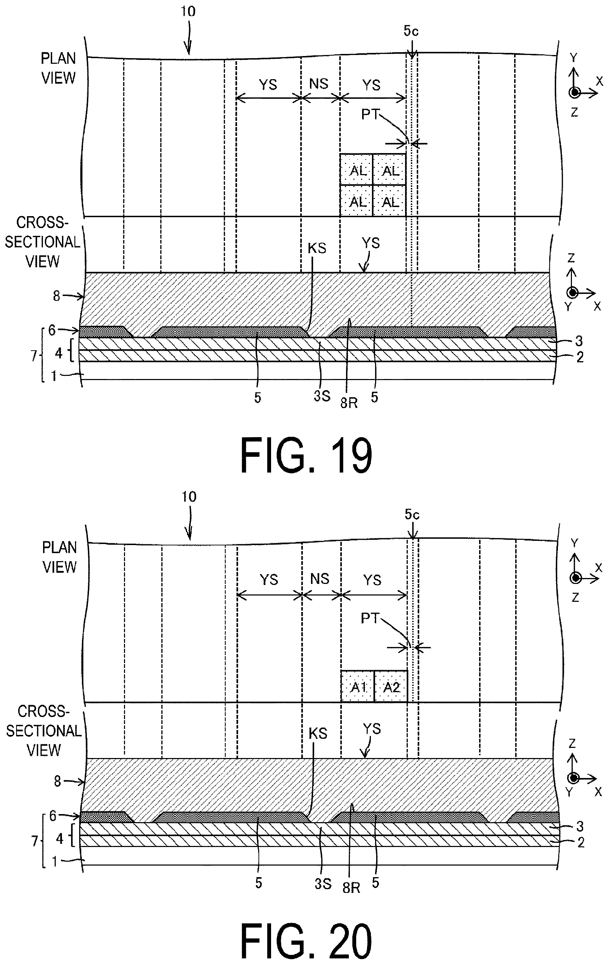

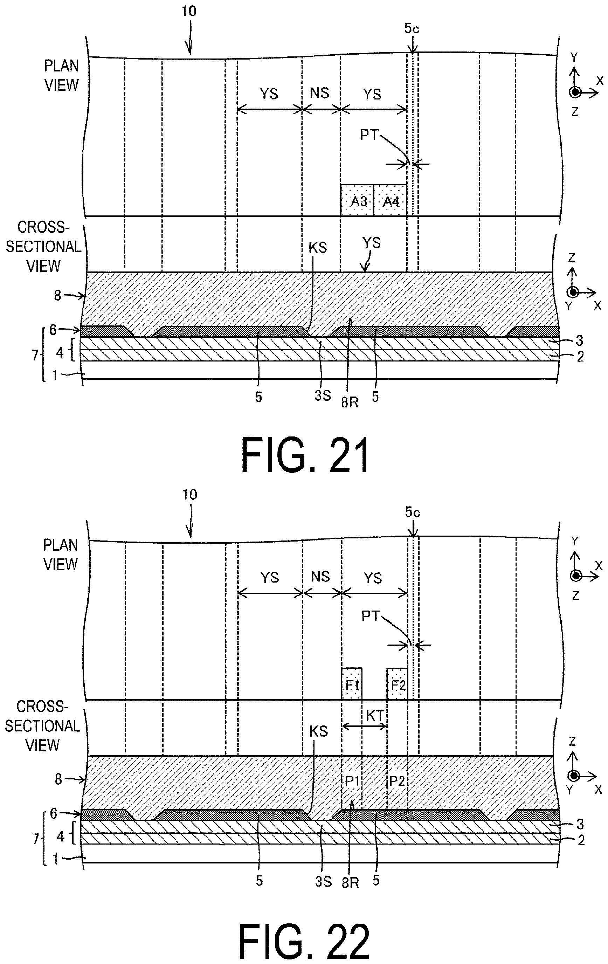

FIG. 19 to FIG. 22 each include a plan view and a schematic view illustrating evaluation of a semiconductor substrate in another configuration (an integrated type in which an ELO semiconductor layer does not have an edge face on a mask). Also, in this case, it was found that the evaluation criteria 1 to 16 mentioned above were satisfied.

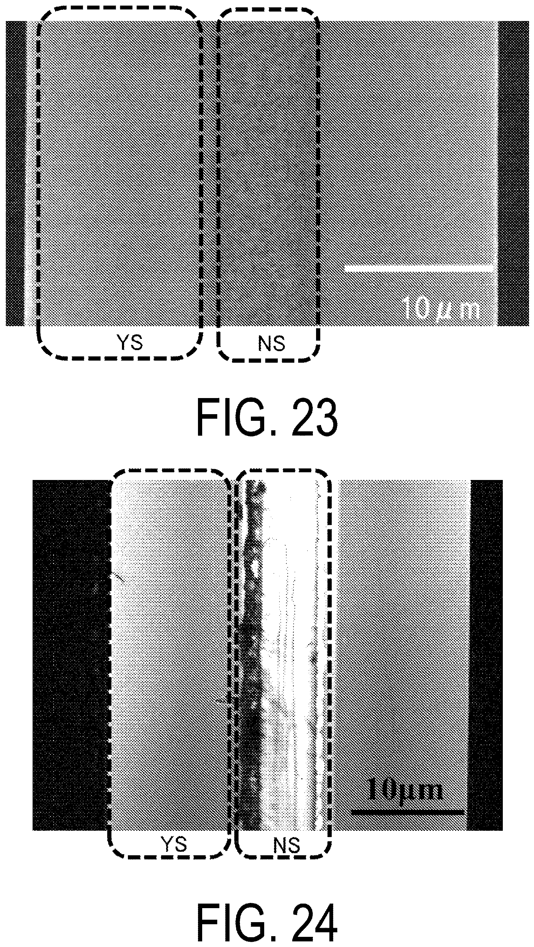

FIG. 23 is a cathode luminescence (CL) image obtained by taking the ELO semiconductor layer 8 in the semiconductor substrate 10 (the main substrate is a silicon substrate) as an imaging subject. Neither a dark spot nor a dark line is observed in the effective portion YS. Only in the non-effective portion NS, approximately 10¹⁹/cm² threading dislocations due to a difference in lattice constant between the silicon substrate and GaN are present.

FIG. 24 is a cathode luminescence (CL) image obtained by taking the ELO semiconductor layer 8 in the semiconductor substrate 10 (the main substrate is a sapphire substrate) as an imaging subject. Since the ELO semiconductor layer 8 is mechanically peeled from the template substrate, the non-effective portion NS is slightly damaged and the peeled surface is not flat, thus the CL image is slightly disordered. However, a dark spot, a dark line, or the like, which is a threading dislocation, is not seen in the effective portion YS, or a low dislocation density is achieved.

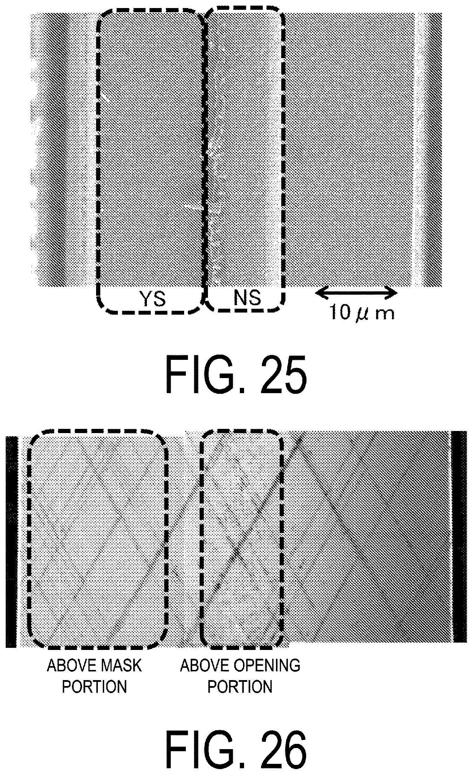

FIG. 25 is a CL image obtained by taking the ELO semiconductor layer back surface (peeled surface) in the semiconductor substrate 10 as an imaging subject. The CL image shows that neither a void nor adhesion is observed in the effective portion YS.

### Reference Examples of ELO Film Formation

FIG. 26 is a CL image of a surface of a GaN layer of a reference example. In this reference example, sapphire is used as the main substrate, and a GaN layer is film-formed by the ELO method. Both dark spots (10¹⁸ to 10¹⁹/cm²) and dark lines, which are high-density threading dislocations, are present above the opening portion. Above the mask portion as well, dark spots and dark lines are observed although the density is lower than that above the opening portion.

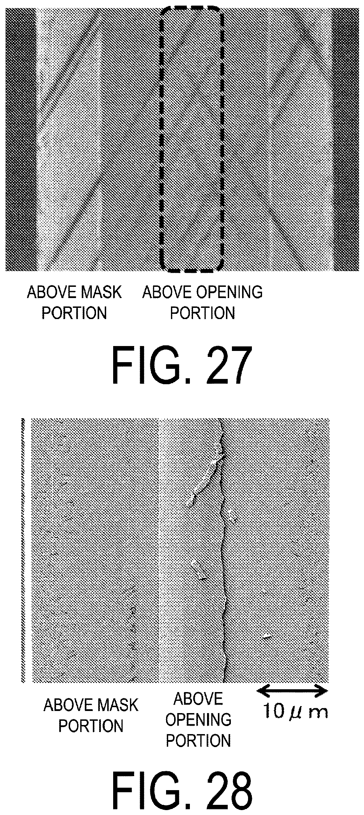

FIG. 27 is a CL image of a surface of a GaN layer of a reference example. In this reference example, silicon is used as the main substrate, and a GaN layer is film-formed by the ELO method. Approximately 10¹⁹/cm² dark spots are observed above the opening portion, and dark lines are observed also above the mask portion.

FIG. 28 is a CL image of a back surface of a GaN layer of a reference example. In this reference example, silicon is used as the main substrate, and a GaN layer is film-formed by the ELO method. A large number of voids are seen at end portions above the mask portion.

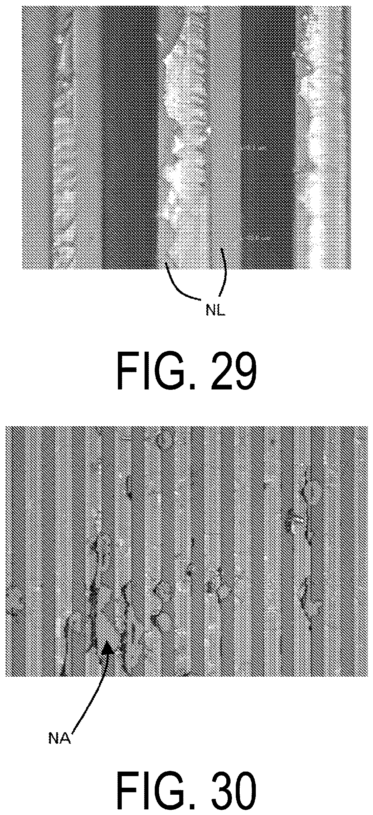

FIG. 29 is a light microscope image obtained by taking a back surface (peeled surface) of a GaN layer having been film-formed by the ELO method in a reference example as an imaging subject. Adhesion NL (reaction layer) between the mask portion and the GaN layer can be seen. When such a GaN layer is mechanically peeled from the mask portion (for example, by using a diamond pen), the GaN layer and the mask portion are peeled together from the template substrate as depicted in a peeling region NA in FIG. 30.

The reference examples indicate that the use of only the ELO method does not make it possible to eliminate voids and adhesion and significantly decrease surface defects above the mask portion. As for dark lines (linear defects), their reduction is of great significance because when they occur, they affect a wide range.

### Example 1

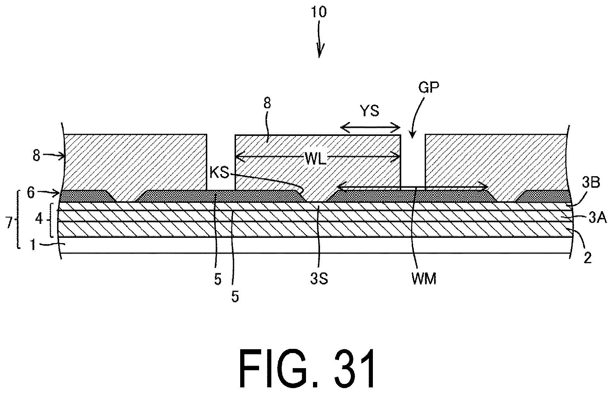

FIG. 31 is a cross-sectional view illustrating a configuration of a semiconductor substrate of Example 1. A silicon substrate having a (111) plane was used as the main substrate 1. The buffer layer 2 of the underlying layer 4 was an AlN layer (for example, 30 nm). The seed layer 3 of the underlying layer 4 was a graded layer in which an Al_{0.6}Ga_{0.4}N layer (for example, 300 nm) as a first layer and a GaN layer (for example, 1 to 2 µm) as a second layer were formed in that order. That is, the composition ratio of Ga (1/2 = 0.5) in the second layer (Ga : N = 1 : 1) is greater than the composition ratio of Ga (0.6/2 = 0.3) in the first layer (Al : Ga : N = 0.6 : 0.4 : 1).

As the mask layer 6, a laminate body in which a silicon oxide film (SiO₂) and a silicon nitride film (SiN) were formed in that order was used. The silicon oxide film has a thickness of 0.3 µm, for example, and the silicon nitride film has a thickness of 70 nm, for example. Each of the silicon oxide film and the silicon nitride film was film-formed by a plasma chemical vapor deposition (CVD) method.

The semiconductor layer 8 was a GaN layer, and ELO film formation was performed using an MOCVD device. First, the ELO semiconductor layer 8 was selectively grown on the surface of the seed layer 3 (the GaN layer of the second layer) exposed to the opening portion KS, and subsequently laterally grown on the mask portion 5. At this time, the growth was stopped before the semiconductor layers laterally grown from both sides of the mask portion 5 met each other. The width of the gap GP at this time was 2 µm.

A width WM of the mask portion 5 was 50 µm, the width of the opening portion KS was 5 µm, a lateral width WL of the ELO semiconductor layer 8 was 53 µm, and the width (size in the X direction) of the effective portion YS was 24 µm. The layer thickness of the ELO semiconductor layer 8 was 5 µm, and the aspect ratio of the ELO semiconductor layer 8 was given by a relation of 53 µm/5 µm = 10.6, thus a very high aspect ratio was achieved.

When the semiconductor substrate 10 obtained in Example 1 was evaluated, it was found that the above-described evaluation criteria 1 to 16 were satisfied.

The peeling of the semiconductor layer 8 during the evaluation of the back surface of the semiconductor layer 8 may be performed as follows. For example, when the mask layer 6 is made of an oxide film, a nitride film, or an oxynitride film of silicon, the semiconductor substrate 10 having been subjected to the element separation step (see FIGs. 8 and 9) is immersed in an etchant of hydrofluoric acid for about 10 to 60 minutes, thus the mask layer 6 is dissolved in the etchant and the semiconductor layer 8 may be peeled from the template substrate 7.

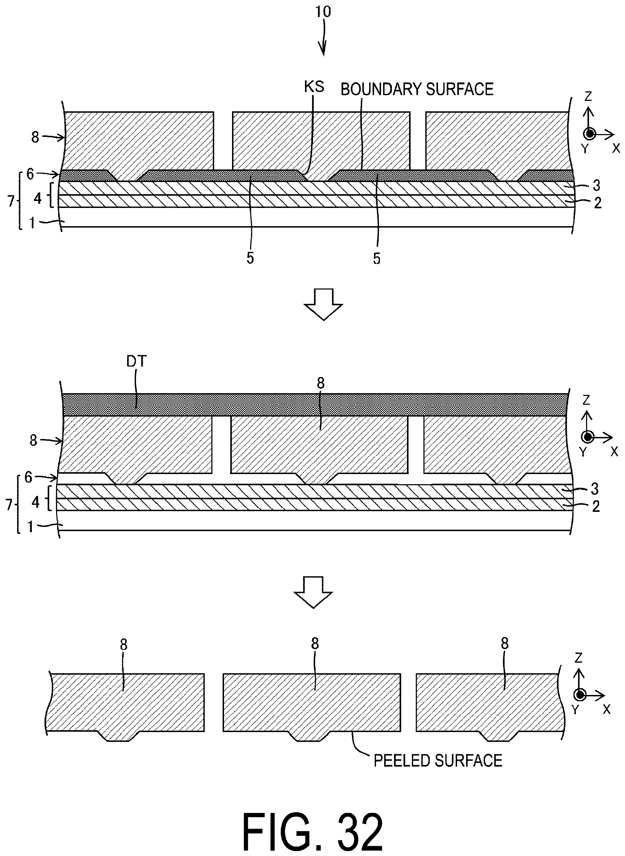

As another peeling method, as illustrated in FIG. 32, the semiconductor substrate 10 may be immersed in an etchant of hydrofluoric acid to dissolve the mask layer 6, then an adhesive tape (for example, an adhesive dicing tape used when dicing a semiconductor wafer) may be attached to the surface of the semiconductor layer 8, and the temperature of the semiconductor substrate 10 with the adhesive tape attached thereto as is may be lowered to a low temperature using a Peltier element. At this time, the adhesive tape generally having a larger thermal expansion coefficient than the semiconductor contracts considerably and applies stress to the semiconductor layer 8. Since the semiconductor layer 8 is bonded to the template substrate 7 only in the opening portion KS and the mask portion 5 has been removed, the stress from the adhesive tape is effectively applied to a bonding portion with the template substrate 7, and consequently the bonding portion may be mechanically cleaved or broken. In other words, dry etching is not needed for the removal of the bonding portion.

### Example 2

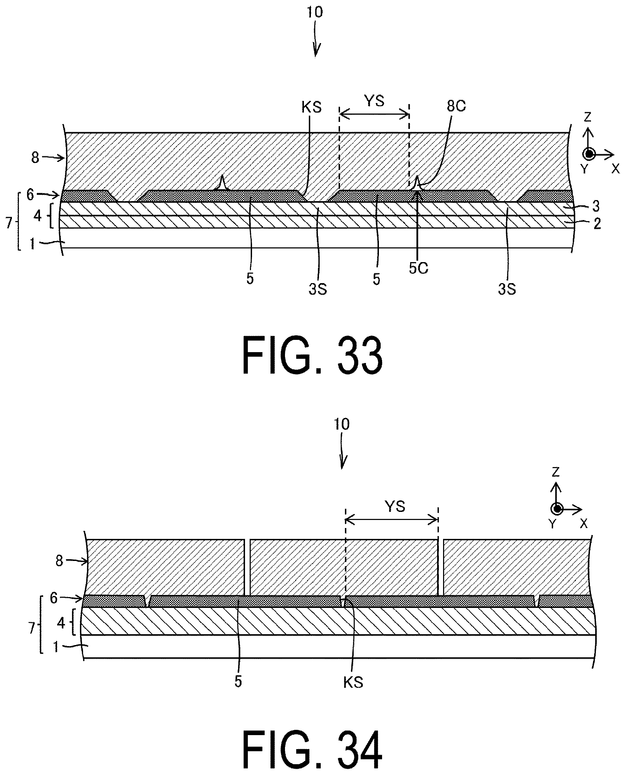

FIG. 33 is a cross-sectional view illustrating a configuration of a semiconductor substrate of Example 2. In Example 2, an integrated type is employed in which the ELO semiconductor layer 8 does not have an edge face on the mask portion 5. The width of the mask portion 5 is 50 µm, and the width of the opening portion KS is 5 µm. From the viewpoint of alleviation of film stress, the height of the hollow portion 8C is preferably 1 µm or more. The width of the bottom surface of the hollow portion 8C is also preferably 1 µm or more, and more preferably 2 µm or more.

When the semiconductor substrate 10 obtained in Example 2 was evaluated, it was found that the above-described evaluation criteria 1 to 16 were satisfied.

### Example 3

FIG. 34 is a cross-sectional view illustrating a configuration of a semiconductor substrate of Example 3. In Example 3, the width of the opening portion KS was 700 nm being 1 µm or less, and the width of the mask portion 5 was 100 µm. In Example 3, since the effective portion YS can be made wide, the configuration of Example 3 is suitable for a high-power laser semiconductor element (with a ridge width of about 40 µm) or the like. FIG. 34 illustrates a structure in which the semiconductor layer 8 has an edge face on the mask portion 5, but the semiconductor layer 8 may be of an integrated type having no edge on the mask portion 5.

When the semiconductor substrate 10 obtained in Example 3 was evaluated, it was found that the above-described evaluation criteria 1 to 16 were satisfied.

### Example 4

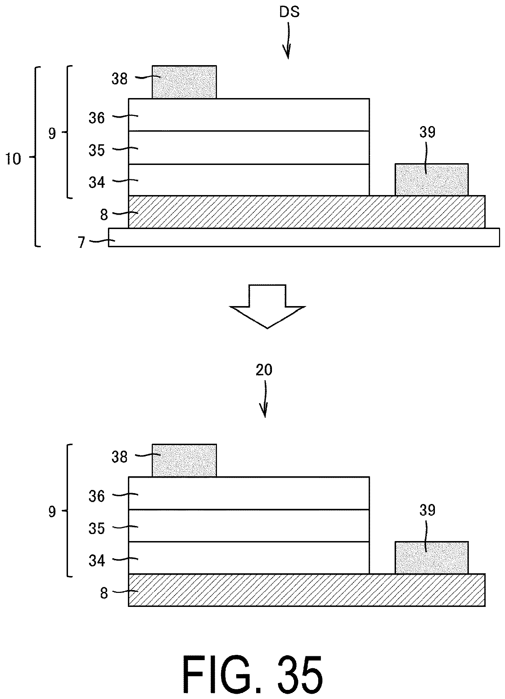

FIG. 35 is a cross-sectional view illustrating a configuration of Example 4. In Example 4, the function layer 9 constituting an LED is film-formed on the semiconductor layer 8. The semiconductor layer 8 is an n-type layer doped with, for example, silicon. The function layer 9 includes an active layer 34, an electron blocking layer 35, and a GaN-based p-type semiconductor layer 36 in that order from the bottom layer side. The active layer 34 is a multi-quantum well (MQW), and includes an InGaN layer and a GaN layer. The electron blocking layer 35 is, for example, an AlGaN layer. The GaN-based p-type semiconductor layer 36 is, for example, a GaN layer. An anode 38 is formed to be in contact with the GaN-based p-type semiconductor layer 36, and a cathode 39 is formed to be in contact with the semiconductor layer 8.

Voids in the back surface of the semiconductor layer cause surface defects (line defects) and degrade the characteristics of the semiconductor device. When the semiconductor device is a light emitting element, the voids in the back surface of the semiconductor layer reduce the in-plane uniformity of the emitted light. In Example 6, the element portion (light emitting element portion) DS is formed on the ELO semiconductor layer 8, and the semiconductor device 20 as a light emitting element can be obtained by peeling off the element portion DS, thus the above problems may be improved. Specifically, no defect was observed in the light emitting region of the semiconductor device 20.

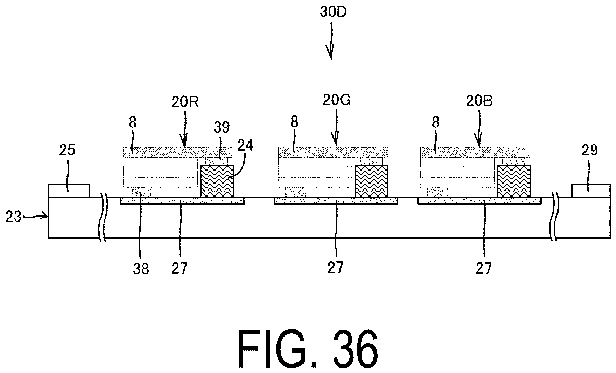

FIG. 36 is a cross-sectional view illustrating an application example of Example 4. According to Example 4, a red micro LED 20R, a green micro LED 20G, and a blue micro LED 20B may be obtained, and a micro LED display 30D (electronic device) may be constituted by mounting these LEDs on the drive substrate (TFT substrate) 23. As an example, the red micro LED 20R, the green micro LED 20G, and the blue micro LED 20B are mounted on a plurality of pixel circuits 27 of the drive substrate 23 via a conductive resin 24 (for example, an anisotropic conductive resin) or the like, and then the control circuit 25, a driver circuit 29, and the like are mounted on the drive substrate 23. The drive substrate 23 may include part of the driver circuit 29.

### Example 5

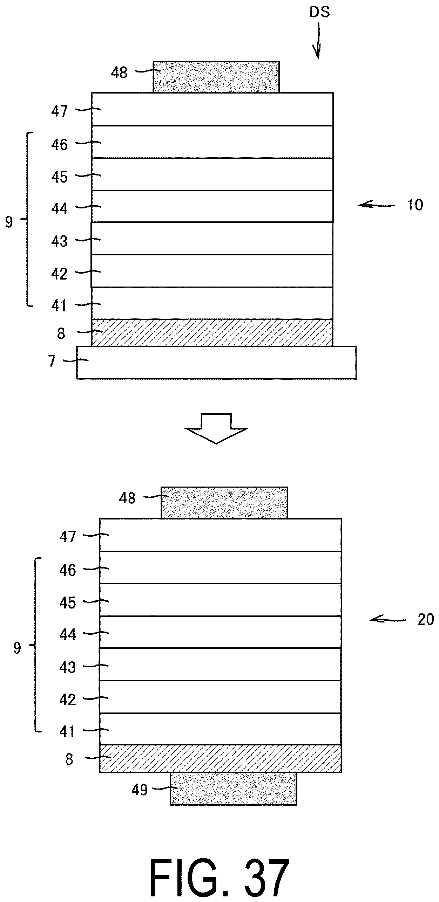

FIG. 37 is a cross-sectional view illustrating a configuration of Example 5. In Example 5, the function layer 9 constituting a semiconductor laser is film-formed on the semiconductor layer 8. The function layer 9 includes an n-type light cladding layer 41, an n-type light guide layer 42, an active layer 43, an electron blocking layer 44, a p-type light guide layer 45, a p-type light cladding layer 46, and a GaN-based p-type semiconductor layer 47 in that order from the bottom layer side. For each of the guide layers 42 and 45, an InGaN layer may be used. A GaN layer or AlGaN layer may be used for each of the cladding layers 41 and 46. An anode 48 is formed to be in contact with the GaN-based p-type semiconductor layer 47.

In Example 5, as depicted in FIG. 37, after the element portion DS is peeled off, a cathode 49 is formed on the back surface of the semiconductor layer 8. Accordingly, the quality of the back surface of the semiconductor layer 8 affects the device characteristics.

### Example 6

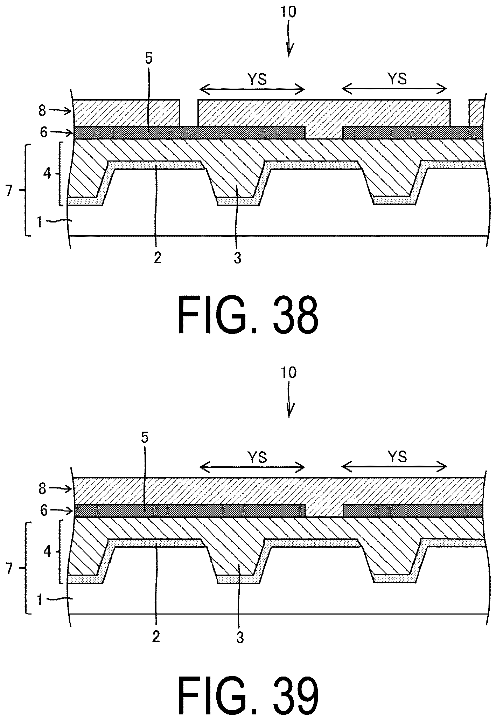

FIG. 38 is a cross-sectional view illustrating a configuration of Example 6. FIG. 39 is a cross-sectional view illustrating another configuration of Example 6. In Example 6, a sapphire substrate having an uneven surface is used for the main substrate 1. The underlying layer 4 includes the buffer layer 2 and the seed layer 3. The semiconductor layer 8 may be of a type having an edge face on the mask 5 (FIG. 38), or may be of an integrated type having no edge face on the mask (FIG. 39). In Example 6, a GaN layer having a (20-21) plane may be film-formed as the underlying layer 4 on the main substrate 1. In this case, the ELO semiconductor layer 8 becomes the (20-21) plane, which is a crystal principal plane, in the underlying layer 4, and the ELO semiconductor layer 8 of a semi-polar plane may be obtained. By providing a function layer for a laser or an LED on the semi-polar plane, an advantage is obtained in that the piezoelectric field is weak and the probability of recombination of electrons and holes is increased in the active layer. A GaN layer having a (11-22) plane may be film-formed as the underlying layer 4 on the main substrate 1 by using a sapphire substrate having an uneven surface.

### Manufacturing Apparatus

A method for manufacturing the semiconductor substrate 10 includes at least a step of forming the semiconductor layer 8 on the template substrate 7 by using the ELO method. A step of forming the underlying layer 4 and the mask layer 6 on the main substrate 1 may be included.

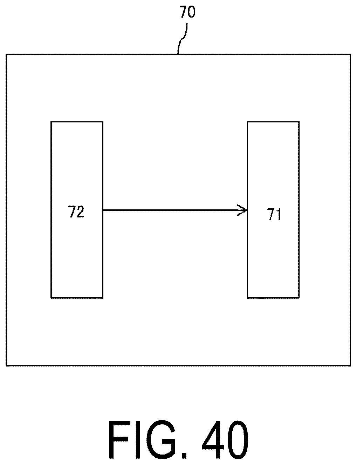

The semiconductor substrate 10 may be manufactured by, for example, a semiconductor substrate manufacturing apparatus illustrated in FIG. 40. The semiconductor substrate manufacturing apparatus 70 at least includes a semiconductor layer forming unit 71 configured to perform the step of forming the semiconductor layer 8 on the template substrate 7 by using the ELO method, and a controller 72 configured to control the semiconductor layer forming unit 71. The semiconductor layer forming unit 71 may include an MOCVD device, and the controller 72 may include a processor and a memory. The controller 72 may be configured to control the semiconductor layer forming unit 71 by executing a program stored in a built-in memory, a communicable communication apparatus, or an accessible network, for example, and the above program, a recording medium storing the above program therein, and the like are also included in the present embodiment. The semiconductor substrate manufacturing apparatus 70 may include a template substrate forming unit configured to perform a step of forming the underlying layer 4 and the mask layer 6 on the main substrate 1, and a function layer forming unit configured to perform a step of forming the function layer 9 on the semiconductor layer 8. A semiconductor device manufacturing apparatus configured to perform an element peeling step may also be constructed. The semiconductor device manufacturing apparatus may perform an element separation step. The semiconductor device manufacturing apparatus may include the semiconductor substrate manufacturing apparatus 70.

### Supplementary Note

In the present disclosure, the invention has been described above based on the various drawings and examples. However, the invention according to the present disclosure is not limited to each embodiment described above. That is, the embodiments of the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, a person skilled in the art can easily make various variations or modifications based on the present disclosure. Note that these variations or modifications are included within the scope of the present disclosure.

### REFERENCE SIGNS

1 Main substrate
2 Buffer layer
3 Seed layer
3S Seed portion
4 Underlying layer
5 Mask portion
6 Mask layer
8 Semiconductor layer
9 Function layer
10 Semiconductor substrate
20 Semiconductor device
30 Electronic device
70 Manufacturing apparatus of semiconductor substrate
KS Opening portion
YS Effective portion

## Claims

1. A semiconductor substrate, comprising:
a main substrate having a lattice constant different from a lattice constant of a GaN-based semiconductor;
a mask layer located above the main substrate and comprising an opening portion and a mask portion;
a seed portion overlapping the opening portion in a plan view; and
a semiconductor layer comprising a GaN-based semiconductor and disposed on the seed portion and the mask portion, wherein
the semiconductor layer comprises an effective portion located between the opening portion and a center of the mask portion in a plan view,
an upper surface of the effective portion comprises at least one low-level defective region with a size of 10 µm in a first direction along a width direction of the opening portion and 10 µm in a second direction orthogonal to the first direction, and
in the low-level defective region, a line defect is not measured by a CL method.

2. The semiconductor substrate according to claim 1, wherein
the upper surface of the effective portion comprises a plurality of low-level defective regions arranged in the first direction.

3. The semiconductor substrate according to claim 1 or 2, wherein
the upper surface of the effective portion comprises a plurality of low-level defective regions arranged in the second direction.

4. The semiconductor substrate according to any one of claims 1 to 3, wherein
a size in the first direction of the effective portion is larger than the width of the opening portion.

5. The semiconductor substrate according to any one of claims 1 to 4, wherein
a ratio of the size in the first direction to a thickness of the effective portion is 2.0 or more.

6. A semiconductor substrate, comprising:
a main substrate having a lattice constant different from a lattice constant of a GaN-based semiconductor;
a mask layer located above the main substrate and comprising an opening portion and a mask portion;
a seed portion overlapping the opening portion in a plan view; and
a semiconductor layer comprising a GaN-based semiconductor and disposed on the seed portion and the mask portion, wherein
the semiconductor layer comprises an effective portion located between the opening portion and a center of the mask portion in a plan view,
the effective portion comprises, at a boundary surface with the mask portion,
a first region having a size of 10 µm in a first direction along a width direction of the opening portion and 10 µm in a second direction orthogonal to the first direction, and
a second region having a size identical to the above-mentioned size, located on the center side of the mask portion relative to the first region, and having an interval with the center of the mask portion, the interval being 30% or less the width of the mask portion, and
when the effective portion is peeled from the mask portion, the number of recessed portions having a major axis of 0.1 µm or more in the first region is smaller than the number of recessed portions having a major axis of 0.1 µm or more in the second region.

7. The semiconductor substrate according to claim 6, wherein
the major axis of the recessed portions present in the first region is 1 µm or less.

8. A semiconductor substrate, comprising:
a main substrate having a lattice constant different from a lattice constant of a GaN-based semiconductor;
a mask layer located above the main substrate and comprising an opening portion and a mask portion;
a seed portion overlapping the opening portion in a plan view; and
a semiconductor layer comprising a GaN-based semiconductor and disposed on the seed portion and the mask portion, wherein
the semiconductor layer comprises an effective portion located between the opening portion and a center of the mask portion in a plan view,
the effective portion comprises, at a boundary surface with the mask portion,
a first region having a size of 10 µm in a first direction along a width direction of the opening portion and 10 µm in a second direction orthogonal to the first direction, and
a second region having a size identical to the above-mentioned size, located on the center side of the mask portion relative to the first region, and having an interval with the center of the mask portion, the interval being 30% or less the width of the mask portion, and
the number of voids having a major axis of 0.1 µm or more in the first region is smaller than the number of voids having a major axis of 0.1 µm or more in the second region.

9. The semiconductor substrate according to any one of claims 6 to 8, wherein
the effective portion comprises, at the boundary surface with the mask portion,
a third region having a size of 10 µm in the first direction along the width direction of the opening portion and 10 µm in the second direction, and
a fourth region having a size identical to the above-mentioned size, located closer to the center side of the mask portion than the third region, and having an interval with the center of the mask portion, the interval being 30% or less the width of the mask portion, and
when the effective portion is peeled from the mask portion, an adhesion area in the third region is smaller than an adhesion region in the fourth region.

10. The semiconductor substrate according to claim 9, wherein
the third region is a non-adhesion region in which adhesion with the mask portion is not observed when the effective portion is peeled from the mask portion.

11. A semiconductor substrate, comprising:
a main substrate having a lattice constant different from a lattice constant of a GaN-based semiconductor;
a mask layer located above the main substrate and comprising an opening portion and a mask portion;
a seed portion overlapping the opening portion in a plan view; and
a semiconductor layer comprising a GaN-based semiconductor and disposed on the seed portion and the mask portion, wherein
the semiconductor layer comprises an effective portion located between the opening portion and a center of the mask portion in a plan view,
the effective portion comprises a first portion, and a second portion farther from the opening portion than the first portion and having an interval with the opening portion, the interval being 10 µm or more, and
when a surface roughness of a peeled surface obtained when the first portion is peeled from the mask portion is defined as first surface roughness, and a surface roughness of a peeled surface obtained when the second portion is peeled from the mask portion is defined as second surface roughness, the first surface roughness is less than or equal to the second surface roughness.

12. The semiconductor substrate according to claim 11, wherein
a value of a ratio of the second surface roughness to the first surface roughness is from 1.0 to 10.

13. The semiconductor substrate according to claim 11 or 12, wherein
a peeled surface obtained when the effective portion is peeled from the mask portion comprises a flat region having a size of 10 µm in a first direction along a width direction of the opening portion and 10 µm in a second direction orthogonal to the first direction and comprising no recessed portion with a major axis of 0.1 µm or more.

14. The semiconductor substrate according to any one of claims 11 to 13, wherein
the second surface roughness is less than 10 nm.

15. The semiconductor substrate according to any one of claims 11 to 14, wherein
in a plan view, the first portion is adjacent to the opening portion, and an interval between the second portion and the center of the mask portion is 30% or less a width of the mask portion.

16. The semiconductor substrate according to any one of claims 11 to 15, wherein
when such an area ratio that the recessed portions with a major axis of 0.1 µm or more contained in the peeled surface of the first portion occupy the peeled surface is defined as a first recessed portion occupancy ratio, and such an area ratio that the recessed portions with a major axis of 0.1 µm or more contained in the peeled surface of the second portion occupy the peeled surface is defined as a second recessed portion occupancy ratio, the first recessed portion occupancy ratio is equal to or less than the second recessed portion occupancy ratio.

17. The semiconductor substrate according to any one of claims 11 to 16, wherein
an impurity concentration in the peeled surface of the first portion is higher than an impurity concentration in the peeled surface of the second portion.

18. The semiconductor substrate according to any one of claims 1 to 17, wherein
the mask portion is made of silicon oxide.

19. The semiconductor substrate according to any one of claims 1 to 18, wherein
a threading dislocation density in the upper surface of the effective portion is 5 × 10⁶ pieces/cm² or less.

20. The semiconductor substrate according to any one of claims 1 to 19,wherein
the width direction of the opening portion is a <11-20> direction of the semiconductor layer.

21. The semiconductor substrate according to any one of claims 1 to 20, further comprising:
a seed layer located above the main substrate and containing a group III atom other than Ga, Ga, and a nitrogen atom, wherein
the seed layer comprises a first layer on the main substrate side and a second layer above the first layer, and
a composition ratio of Ga in the second layer is larger than the composition ratio of Ga in the first layer.

22. The semiconductor substrate according to claim 21, further comprising:
a buffer layer located between the main substrate and the seed layer and containing the group III atom other than Ga.

23. The semiconductor substrate according to claim 22, wherein
the group III atom other than Ga is Al.

24. The semiconductor substrate according to any one of claims 1 to 23, wherein
the main substrate is a silicon substrate.

25. The semiconductor substrate according to any one of claims 1 to 24, wherein
the width of the mask portion is 20 µm to 200 µm.

26. The semiconductor substrate according to any one of claims 1 to 25, wherein
the semiconductor layer comprises an edge face on the mask portion.

27. The semiconductor substrate according to any one of claims 1 to 25, wherein
the semiconductor layer is formed in an integrated shape comprising no edge face on the mask portion.

28. The semiconductor substrate according to any one of claims 1 to 27, further comprising:
a function layer disposed on the semiconductor layer.

29. A semiconductor device, comprising:
the semiconductor layer and the function layer according to claim 28.

30. An electronic device, comprising:
the semiconductor substrate according to claim 28.

31. An electronic device, comprising:
the semiconductor device according to claim 29.
